# EUROPEAN PATENT SPECIFICATION

(11) **EP 3 829 279 B1**
(45) Date of publication and mention of the grant of the patent: **24.01.2024**
(21) Application number: 19315150.3
(22) Date of filing: 29.11.2019
(51) Int. Cl.: H05K 7/20

(54) **COOLING ARRANGEMENT FOR AUTONOMOUS COOLING OF A RACK**
KÜHLANORDNUNG ZUR AUTONOMEN KÜHLUNG EINES SCHRANKS
AGENCEMENT DE REFROIDISSEMENT POUR LE REFROIDISSEMENT AUTONOME D'UN BÂTI

(43) Date of publication of application: 02.06.2021
(73) Proprietor: OVH, 59100 Roubaix (FR)
(72) Inventor: Chehade, Ali, 59242 Templeuve (FR); Bauduin, Hadrien, 59650 Villeneuve d'Ascq (FR); Bauchart, Grégory Francis Louis, 59150 Wattrelos (FR)
(74) Representative: BCF Global

(56) References cited:
- EP-A1- 3 654 744
- US-A1- 2010 275 618
- US-A1- 2013 138 252
- US-A1- 2013 174 421
- US-A1- 2017 181 328
- US-A1- 2018 192 552
- US-B1- 7 905 096

## Description

### FIELD

The present technology relates to cooling techniques for electronic equipment. In particular, a cooling arrangement for autonomous cooling of a rack is disclosed.

### BACKGROUND

Electronic equipment, for example servers, memory banks, computer discs, and the like, is conventionally grouped in equipment racks. Large data centers and other large computing facilities may contain thousands of racks supporting thousands or even tens of thousands of servers.

The racks, including equipment mounted in their backplanes, consume large amounts of electric power and generate significant amounts of heat. Cooling needs are important in such racks. Some electronic devices, such as processors, generate so much heat that they could fail within seconds in case of a lack of cooling.

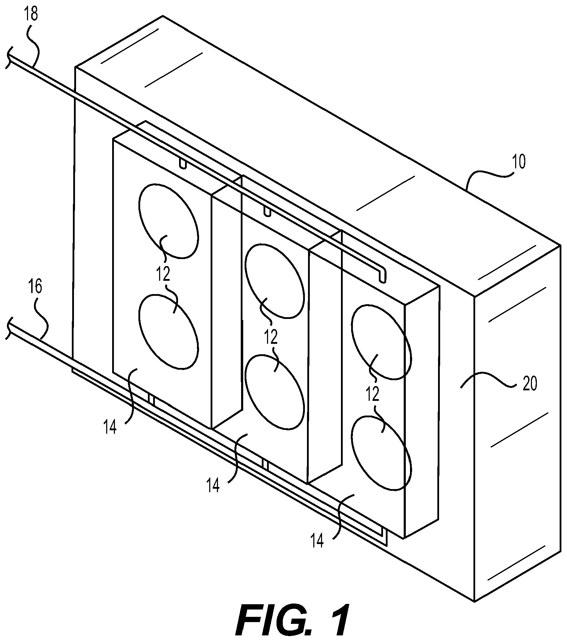

Fans are commonly mounted within equipment racks to provide forced ventilation cooling to rack-mounted equipment. This solution merely displaces some of the heat generated within the racks to the general environment of the data center. Air-to-liquid heat exchangers, finned tubes heat exchangers similar to radiators, may be mounted to the racks to absorb and transport some of this displaced heat to further cooling equipment, for example cooling towers, located outside of the data center. For example, Figure 1 is a highly schematic perspective view of a server rack on which three (3) air-to-liquid heat exchangers are mounted. A server rack 10 hosts a number of servers (not shown) that generate a significant amount of heat. A number of fans 12 (six fans are shown without limiting the present disclosure) expel heated air from the server rack 10 in a direction of three (3) air-to-liquid heat exchangers 14 mounted behind a backplane 20 of the server rack 10. On Figure 1, the air-to-liquid heat exchangers 14 are shown in transparent form in order to render the fans 12 visible. The air-to-liquid heat exchangers 14 receive cold liquid, for example water, from a cold liquid line 16 and return heated liquid to a hot liquid line 18. The airflow having passed through the air-to-liquid heat exchangers 14 is somewhat cooled down to allow maintaining an ambient temperature of the data center to a reasonable level.

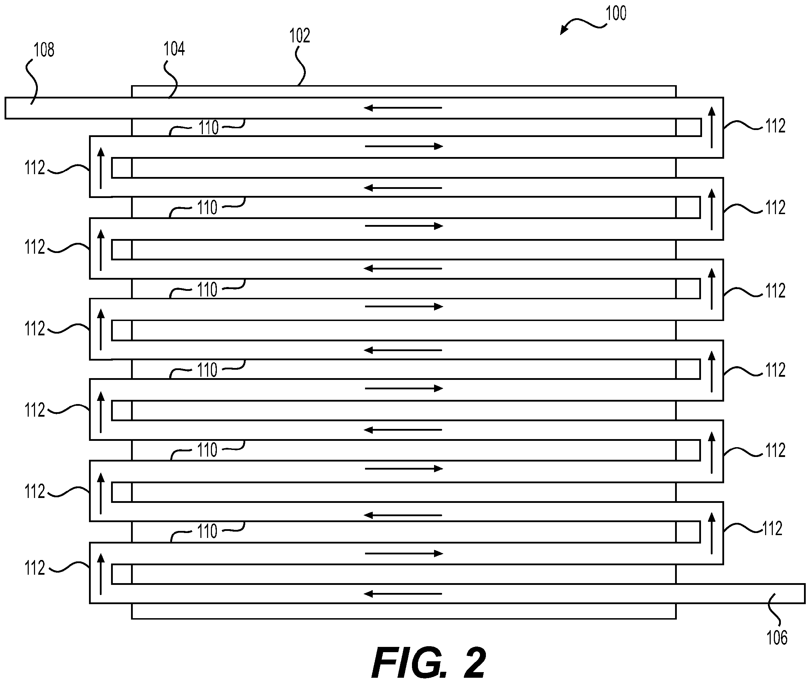

Figure 2 is a schematic diagram of a single-flow air-to-liquid heat exchanger. A single-flow heat exchanger 100 comprises a frame 102 and a continuous internal conduit 104. The continuous internal conduit 104 is connected at one end to liquid inlet 106 and at an opposite end to a liquid outlet 108. The liquid inlet 106 is connectable to a supply line such as the cold liquid line 16 for receiving a cold liquid, for example water. The liquid outlet 108 is connectable to a return line such as the hot liquid line 18 for returning the liquid that, in operation, has absorbed heat from an airflow passing through the frame 102. The continuous internal conduit 104 forms a plurality of interconnected parallel sections 110 that extend within the frame 102.

The liquid inlet 106 is connected to a first interconnected parallel section 110. Each interconnected parallel section 110, except a last one, is connected to a next interconnected parallel section 110 via a generally U-shaped section 112 of the continuous internal conduit 104. The last interconnected parallel section 110 is connected to the liquid outlet 108. Liquid received at the liquid inlet 106 flows within the continuous internal conduit 104 in the direction shown by the various arrows until it reaches the liquid outlet 108. Heat from the air flowing through the frame 102 of the air-to-liquid heat exchanger 100 is absorbed at least in part by the liquid flowing through the continuous internal conduit 104.

The single-flow heat exchanger 100 is thin, especially when compared to a thickness of the server rack 10. Given its thinness, the single-flow heat exchanger 100 adds little to the overall space occupancy of the server rack 10 in the data center. The thinness of the single-flow heat exchanger 100 further allows its mounting on the server rack 10 by use of hinges (not shown) so that the single-flow heat exchanger 100 may be moved aside, as when opening a door, to provide access to components present in the backplane 20 of the rack 10.

The frame 102 occupies most of the overall width of single-flow heat exchanger 100, as only the generally U-shaped section 112 of the continuous internal conduit 104 protrude on each side of the frame 102. Consequently, the single-flow heat exchanger 100 offers a broad surface that may be traversed by a flow of air expelled from the server rack 10.

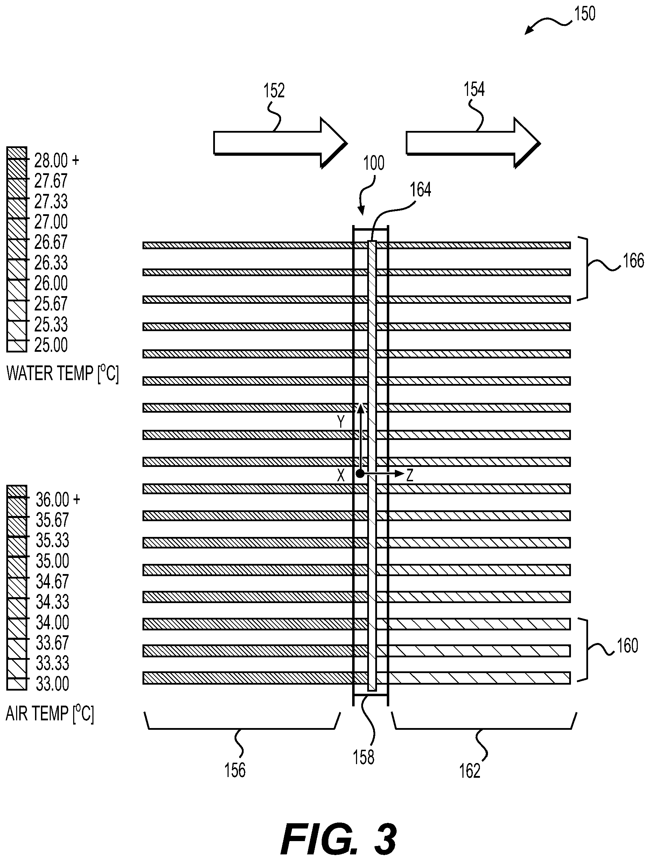

Figure 3 is a visual representation of a stratified temperature pattern of an airflow expelled from the single-flow air-to-liquid heat exchanger of Figure 2. A diagram 150 illustrates a temperature of a flow of air measured in an experimental setup, before and after passing through the single-flow heat exchanger 100. The air flows in the direction of arrows 152 and 154. In a first zone 156 upstream of the air-to-liquid heat exchanger 100, a temperature of the airflow is high due to the generation of heat in the server rack 10, being for example at about 40 degrees (all temperatures are in Celsius). The temperature of the airflow is substantially uniform within the first zone 156. Cold liquid is received at the bottom 158 of the single-flow heat exchanger 100, at a temperature of about 25 degrees. Lower strata 160 of the air flowing in a zone 162 downstream of the single-flow heat exchanger 100 are cooled to about 33 degrees. A temperature of the liquid flowing through the single-flow heat exchanger 100 increases as it passes through the various interconnected parallel sections 110, being continuously exposed to the 40 degrees airflow. The liquid reaches about 28 degrees the top 164 of the single-flow heat exchanger 100. Consequently, a topmost section of the single-flow heat exchanger 100 is less efficient in cooling the flow of air in upper strata 166, which are only cooled to about 36 degrees.

This lack of homogeneity of the flow of air expelled from the single-flow heat exchanger 100 causes a plurality of problems.

One problem is that it becomes difficult to place a plurality of server racks 10 in close proximity to one another because the air expelled from a first server rack 10 and aspired by the fans 12 of a second, proximally located server rack 10, is not suitable for efficiently cooling of that second server rack 10. This is particularly the case when it is desired to place a plurality of server racks 12 in front of one another, with the same orientation.

Another problem relates to the monitoring of cooling efficiency. Such monitoring is important as safety measures may need to be applied without delay in case of cooling failure. In the data center, temperature sensors (not shown) are positioned in various places on the server racks 10. When such temperature sensors are mounted on the single-flow heat exchangers 100, slight variations in the placement of these temperatures sensors on the surface of each single-flow heat exchanger 100 may lead to imprecisions that are detrimental to the overall monitoring of the cooling performance. For example when the interconnected parallel sections 110 extend horizontally, as illustrated on Figure 2, positioning a temperature sensor at different heights on various single-flow heat exchanger 100 may cause to acquire inconsistent measurements.

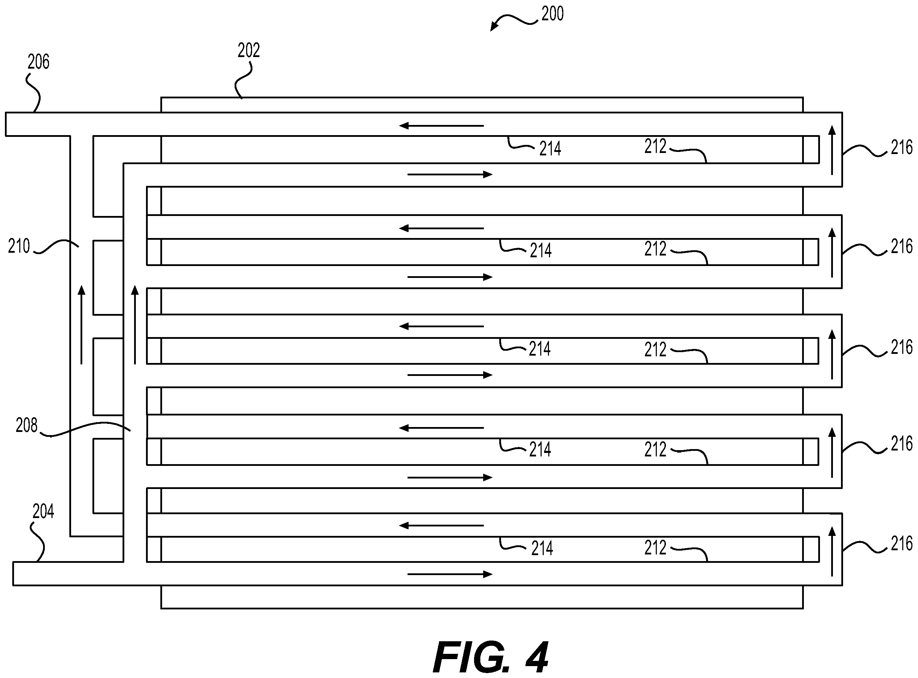

Figure 4 is a schematic diagram of a multi-flow air-to-liquid heat exchanger. A multi-flow air-to-liquid heat exchanger 200 comprises a frame 202, a liquid inlet 204 and a liquid outlet 206. The liquid inlet 204 is connected to a first manifold 208 and the liquid outlet 206 is connected to a second manifold 210. The first and second manifolds 208 and 210 are sometimes collectively called a "nurse" because the first manifold 208 feeds a cold liquid received at the liquid inlet 204 to a first plurality of parallel internal conduits 212, each of which is connected to one of a second plurality of parallel internal conduits 214 via a respective U-shaped link 216, the parallel internal conduits 214 being connected to the liquid outlet 206 via the second manifold 210. The first and second manifolds 208 and 210 as illustrated are located outside of the frame 202 and are positioned in an area where an airflow from the server rack 10 is substantially blocked. The first and second manifolds 208 and 210 usually have a diameter that is significantly larger than a diameter of the parallel internal conduits 212 and 214 in order for each of the parallel internal conduits 212 and 214 to be fed with substantially equal liquid flows.

When compared to the single-flow heat exchanger 100, multi-flow air-to-liquid heat exchanger 200 is much less subject to cause a temperature stratification of air flowing therethrough. The multi-flow air-to-liquid heat exchanger 200 however brings other disadvantages.

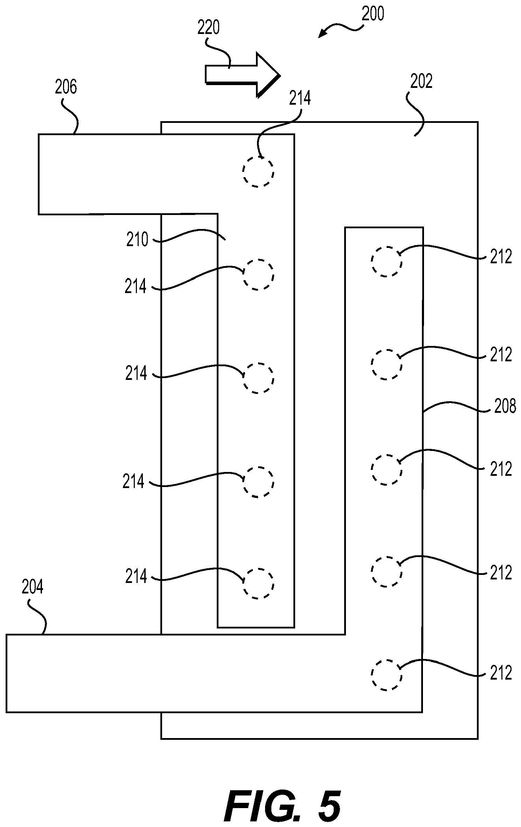

Figure 5 is a schematic side-view of the multi-flow air-to-liquid heat exchanger of Figure 4. On Figure 5, the air expelled from the server rack 10 flows in a direction of the arrow 220. The frame 202 has an important thickness due to the presence of the first and second manifolds 208 and 210. This thickness may become problematic when mounting a large number of multi-flow air-to-liquid heat exchangers 200 on a respectively large number of server racks 10 in the data center. A same number of server racks 10 will occupy more of the floor space of the data center. It may be noted that the multi-flow air-to-liquid heat exchanger as illustrated on Figures 4 and 5 is only a simple example of many possible configurations.

Another disadvantage of the multi-flow air-to-liquid heat exchanger 200, which is also caused by its thickness, is that it cannot conveniently be mounted on the server rack 10 by use of hinges. The multi-flow air-to-liquid heat exchanger 200 needs to be fully dismounted from the server rack 10 to provide access to the backplane 20.

A further disadvantage of the multi-flow air-to-liquid heat exchanger 200 relates to its geometry. The nurse formed by the first and second manifolds 208 and 210 occupies a significant share of the overall surface of the multi-flow air-to-liquid heat exchanger 200, leaving a lesser share of this overall surface that be traversed by a flow of air expelled from the server rack 10, when compared with the single-flow heat exchanger 100.

In addition to the above-mentioned concerns, other concerns relate to the potential failure of cooling equipment, for example due to blockage of liquid conduits. The single-flow heat exchanger 100 and multi-flow air-to-liquid heat exchanger 200 each have a single inlet 106 or 204 and a single outlet 108 or 206, so any blockage of at the level of these inlets and outlets may lead to a complete loss of cooling of the airflow expelled from the server rack 10.

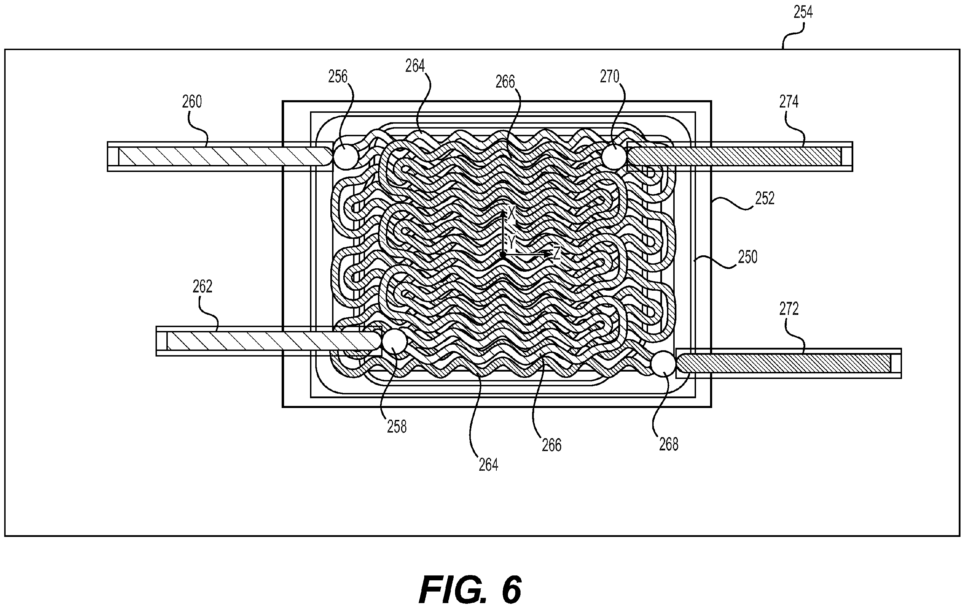

In addition to air-to-liquid heat exchangers, liquid cooling units may be mounted internally in the server rack 10 to directly cool the processors in each server. A non-limiting example of a liquid cooling unit is illustrated on Figure 6, which is a top plan schematic representation of a water block mounted on a processor of a component. A water block 250 is a liquid cooling heat sink, which is thermally coupled to a component to be cooled, for example on a processor 252 of a component 254 mounted within the server rack 10. Water (or another liquid) is circulated through a conduit in the water block 250 to absorb the heat from the component. As the liquid flows out of the water block 250, so does the heat absorbed thereby. In more details, the shown water block 250 is mounted on the processor 252. Figure 6 is not to scale; while perimeters of the water block 250 and of the processor 252 may be similar, their relative sizes in view of the shown size of the component 254 are for illustration purposes only.

The water block 250 comprises two redundant liquid inlets 256 and 258 respectively connectable to redundant conduits 260 and 262 (only their ends is shown) for receiving a cooling liquid. The liquid flows through redundant liquid channels 264 and 266 that zigzag within the water block 250 to maximize the heat absorption potential of the liquid across a surface of the water block 250. The liquid channels 264 and 266 terminate at two redundant liquid outlets 268 and 270 that are respectively connectable to redundant conduits 272 and 274 (only their ends are shown) for hot liquid output. In the illustrated example, the liquid is received at the liquid inlets 256 and 258 at about 35 degrees. The liquid is expelled at the liquid outlets 268 and 270 at about 40.5 to 41.5 degrees.

Known solutions combine air-to-liquid heat exchangers and liquid cooling units in an inefficient manner. While liquid cooling units can efficiently operate with fairly high inlet liquid temperatures, for example 50 degrees, it is desired to maintain a lower ambient air temperature in the datacenter, for example to less than 35 degrees. Supplying liquid at up to 50 degrees to air-to-liquid heat exchangers cannot allow reducing the ambient air temperature to a desired level. Supplying liquid at a much lower inlet temperature, for example 35 degrees, to liquid cooling units would require expensive external liquid cooling equipment.

Liquid flowing in and out of the water blocks 250 or in and out of other liquid cooling units installed in a large number of server racks 10 is conventionally pumped by large pumps and is directed to outside equipment, for example toward cooling towers. In a large computing facility comprising thousands of water blocks 250 that are ultimately fed by a single pump, proper flow control to ensure a sufficient cooling flow in each individual water block 250 may be an unmanageable task. It is also difficult to scale the system because of the presence of large pumps, large reservoirs, and other large pieces of equipment. The use of large pumps and other large equipment greatly increases the cost of the cooling infrastructure. When there is a desire to provide cooling redundancy, the cost of providing redundancy rapidly becomes prohibitive, as is the number and space occupancy of redundant piping elements disposed in all parts of the computing facility.

There is thus a desire to provide an autonomous cooling solution for each server rack 10. There is also a desire tor provide cooling redundancy implemented at the level of a single server rack 10.

Even though the recent developments identified above may provide benefits, improvements are still desirable.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

US 2017/181328 A1 describes a rack Information Handling System (RIHS) that has more than one liquid cooled (LC) node containing heat-generating functional components, each LC node being configured with a system of conduits to receive cooling liquid to regulate the ambient temperature of the node and provide cooling to the functional components inside the node by removing heat generated by the heat-generating functional components. A liquid control subsystem includes electrically-actuated control valves that selectively distribute cooling liquid to LC nodes each comprising a chassis received in a respective chassis-receiving bay of a rack. Liquid sensors detect a parameter of the liquid control subsystem. A liquid controller communicatively coupled to the electrically-actuated control valves and the liquid sensors detect a rack-level liquid event based at least in part on the parameter and communicates to any LC node that is affected by the rack-level liquid event.

US 2013/138252 A1 describes cooling apparatuses and methods which include one or more coolant-cooled structures associated with an electronics rack, a coolant loop coupled in fluid communication with one or more passages of the coolant-cooled structure(s), one or more heat exchange units coupled to facilitate heat transfer from coolant within the coolant loop, and N controllable components associated with the coolant loop or the heat exchange unit(s), wherein N≧1. The N controllable components facilitate circulation of coolant through the coolant loop or transfer of heat from the coolant via the heat exchange unit(s). A controller is coupled to the N controllable components, and dynamically adjusts operation of the N controllable components, based on Z input parameters and one or more specified constraints, to provide a specified cooling to the coolant-cooled structure(s), while limiting energy consumed by the N controllable components, wherein Z≧1.

US 2013/0174421 A1 describes a method for fabricating a cooling apparatus for cooling an electronics rack, which includes an air-to-liquid heat exchanger, one or more coolant-cooled structures, and a tube. The heat exchanger is associated with the electronics rack and disposed to cool air passing through the rack, includes a plurality of coolant-carrying tube sections, each tube section having a coolant inlet and outlet, one of which is coupled in fluid communication with a coolant loop to facilitate flow of coolant through the tube section. The coolant-cooled structure(s) is in thermal contact with an electronic component(s) of the rack, and facilitates transfer of heat from the component(s) to the coolant.

The tube connects in fluid communication one coolant-cooled structure and the other of the coolant inlet or outlet of the one tube section, and facilitates flow of coolant directly between that coolant-carrying tube section of the heat exchanger and the coolant-cooled structure.

US 2018/192552 A1 describes a heat-dissipating system and method of a whole cabinet server system. The system comprises: a whole cabinet server system, a water-cooling plate, a water-cooling coil pipe and a fan; the water-cooling plate is disposed on each designated heat-generating element in each server of the whole cabinet server system; the water-cooling plate is configured to use low-temperature water therein to take away heat generated by the designated heat-generating element; the fan is configured to produce low-temperature air stream which flows through the whole cabinet server system and the water-cooling coil pipe in turn; the water-cooling coil pipe is configured to cool air stream that have absorbed the heat of the whole cabinet server system as low-temperature air stream. The solutions of the present disclosure can be applied to improve the heat-dissipating efficiency and reduce the costs of implementation.

EP 3 654 744 A1 describes a method of cooling an electronics cabinet that includes inducing a flow of cooling air to enter into the electronics cabinet, passing the flow of cooling air over electronic modules arranged within the electronics cabinet to convectively transfer heat to the flow of cooling air from the electronic modules, and directing the flow of cooling air through a door heat exchanger at an end of the electronics cabinet to exhaust the flow of cooling air from the cabinet. A first coolant flow is directed through the door heat exchanger, and heat is transferred from the flow of cooling air to the first coolant flow as they pass through the door heat exchanger. A second coolant flow is circulated through a coolant loop that is arranged within the electronics cabinet, and passes though cold plates that are joined to at least some of the electronic modules to transfer heat from those modules to the second coolant flow. Heat from the second coolant flow is transferred to the first coolant flow in a coolant-to-coolant heat exchanger arranged within the electronics cabinet. Heat is subsequently rejected from the first coolant flow at a location remote from the electronics cabinet.

US 7 905 096 B1 describes a dehumidifying and re-humidifying cooling apparatus and a method for an electronics rack. The apparatus includes a dehumidifying air-to-liquid heat exchanger disposed at an air inlet side of the rack and a re-humidifying air-to-liquid heat exchanger disposed at an air outlet side of the rack. The heat exchangers are in fluid communication with a coolant loop for passing chilled coolant through the heat exchangers, and the dehumidifying heat exchanger dehumidifies ingressing air to the electronics rack to reduce a dew point of air flowing through the rack. A condensate collector disposed at the air inlet side collects liquid condensate from the dehumidifying of ingressing air, and a condensate delivery mechanism delivers the condensate to the re-humidifying heat exchanger to humidify air egressing from the electronics rack.

US 2010/0275618 A1 describes a system for distributing a cooling fluid in a room containing at least one heat generating component including a primary heat exchanger having an inlet for receiving the cooling fluid, a heat exchange section configured to facilitate exchange of heat between airflow in the room and the cooling fluid, and an outlet for exhausting heated cooling fluid from the heat exchange section. The system also includes a secondary heat exchanger having a receiving section connected to the second section of a cooling fluid line for receiving heated cooling fluid, a heat exchange section configured to facilitate exchange of heat between the at least one heat generating component and the heated cooling fluid, and an exhaust section configured to exhaust secondarily heated cooling fluid. The secondary heat exchanger may be in thermal contact with a tertiary heat exchanger positioned to cool a heat generating component. The tertiary heat exchanger may include a loop containing a separate cooling fluid configured to be conveyed to different locations in the heat generating component.

### SUMMARY

Embodiments of the present technology have been developed based on developers' appreciation of shortcomings associated with the prior art.

In particular, such shortcomings may comprise (1) the difficulty in scaling the cooling infrastructure; (2) the cost of the cooling infrastructure and/or (3) the cost of providing redundancy in the cooling infrastructure.

The object of the invention is solved by a cooling arrangement according to claim 1. Preferred embodiments are presented in the dependent claims.

In the context of the present specification, unless expressly provided otherwise, electronic equipment may refer, but is not limited to, "servers", "electronic devices", "operation systems", "systems", "computer-based systems", "controller units", "monitoring devices", a "control devices" and/or any combination thereof appropriate to the relevant task at hand.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 is a highly schematic perspective view of a server rack on which three (3) air-to-liquid heat exchangers are mounted;
Figure 2 is a schematic diagram of a single-flow air-to-liquid heat exchanger;
Figure 3 is a visual representation of a stratified temperature pattern of an airflow expelled from the single-flow air-to-liquid heat exchanger of Figure 2;
Figure 4 is a schematic diagram of a multi-flow air-to-liquid heat exchanger;
Figure 5 is a schematic side-view of the multi-flow air-to-liquid heat exchanger of Figure 4;
Figure 6 is a top plan schematic representation of a water block;
Figure 7 is a highly schematic representation of a pair of air-to-liquid heat exchangers assembled in an anti-parallel configuration in accordance with an embodiment of the present technology;
Figure 8 is a rear perspective view of a server rack having an autonomous and redundant cooling arrangement including a pair of closed loops and a pair of open loops in accordance with an embodiment of the present technology;
Figure 9 is a partial, front perspective view of the server rack of Figure 8;
Figure 10 is a side elevation view of the server rack of Figures 8 and 9 in accordance with an embodiment of the present technology;
Figure 11 is a highly schematic illustration of a cooling arrangement having a closed loop including a liquid cooling unit and an open loop including air-to-liquid heat exchangers;
Figure 12 is a schematic block diagram of a manifold connection between a plurality of water blocks, a pump and a liquid-to-liquid heat exchanger;
Figure 13 is another side elevation view of the server rack of Figures 8 and 9 showing a removal of a module in accordance with an embodiment of the present technology; and
Figure 14 is a visual representation of a homogeneous temperature pattern of an airflow expelled from dual-flow air-liquid heat exchangers assembled in an anti-parallel configuration.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future.

An aspect of the present technology introduces a cooling arrangement for autonomous cooling of a rack, for example a server rack, hosting at least one heat generating component and at least one fan. The cooling arrangement comprises a closed loop and an open loop. The closed loop provides liquid cooling for the heat generating component. The open loop provides cooling for air expelled from the rack by the at least one fan. A cold liquid, for example water, is fed to the open loop and is brought to a warm temperature by the air expelled by the rack. The warm liquid is then fed to a heat exchanger at a junction between the open loop and the closed loop. A hotter liquid of the closed loop is cooled by thermal transfer from the closed loop to the open loop in the heat exchanger. The liquid from the open loop, which has increased in temperature, is expelled from the open loop.

With these fundamentals in place, we will now consider some non-limiting examples to illustrate various implementations of aspects of the present technology.

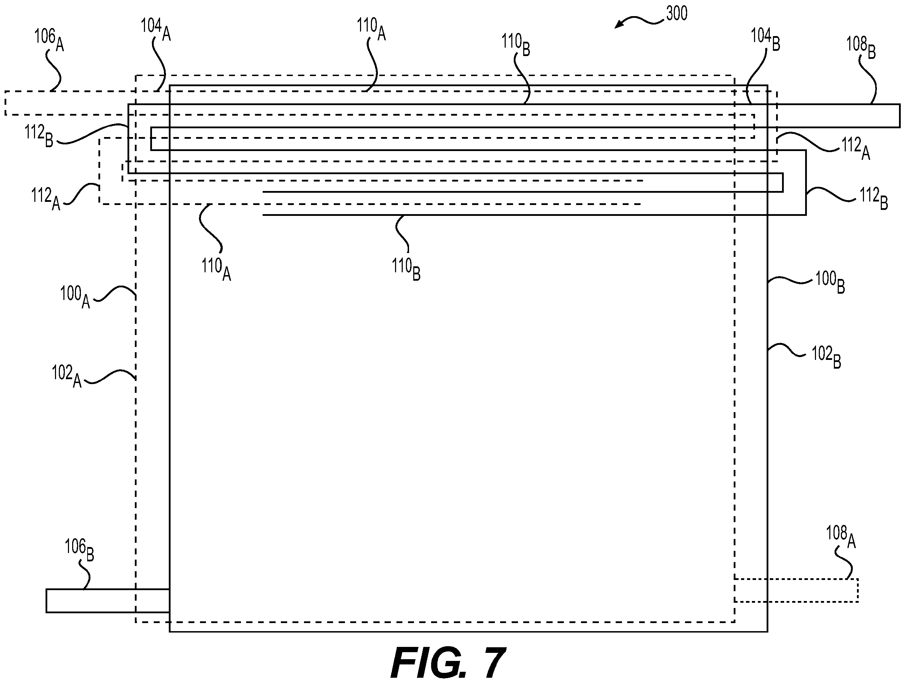

Figure 7 is a highly schematic representation of a pair of air-to-liquid heat exchangers assembled in an anti-parallel configuration in accordance with an embodiment of the present technology. A cooling arrangement 300 that may be mounted on a rack hosting electronic equipment and at least one fan, for example the server rack 10 having the fans 12, comprises at least a pair of air-to-liquid heat exchangers, for example and without limitation, a pair of single-flow heat exchangers 100 as introduced in the description of Figure 2. With continued reference to Figure 7, also considering Figures 1 and 2, an air-to-liquid heat exchanger 100_{A} is shown in dotted lines and another air-to-liquid heat exchanger 100_{B} is shown in solid lines. On Figure 7, the air-to-liquid heat exchangers 100_{A} and 100_{B} are shown as being mounted at an offset from one another; this illustration is solely intended to render visible various parts of the air-to-liquid heat exchangers 100_{A} and 100_{B}. In a practical application, the air-to-liquid heat exchangers 100_{A} and 100_{B} may be aligned so that there is no discernable offset therebetween.

The air-to-liquid heat exchanger 100_{A} is mounted to the server rack 10 so that heated air expelled from the server rack 10 by the one or more fans 12 flows through the air-to-liquid heat exchanger 100_{A}. The air-to-liquid heat exchanger 100a comprises a frame 102_{A}, a liquid inlet 106_{A} mounted to the frame 102_{A} for receiving liquid from a cold supply line, a liquid outlet 108_{A} mounted to the frame 102 for returning liquid to a hot return line, and a continuous internal conduit 104_{A}. The continuous internal conduit 104_{A} forms a plurality of interconnected parallel sections 110_{A} (only some are shown) extending within the frame 102_{A}. Examples of the cold supply line and of the hot return line are shown on later Figures.

The continuous internal conduit 104_{A} connects the liquid inlet 106_{A} to the liquid outlet 108_{A}. In more details, a one of the plurality of interconnected parallel sections 110a is connected to the liquid inlet 106_{A}. Then, each one of the plurality of interconnected parallel sections 110_{A} except a last one is connected to a next one of the plurality of interconnected parallel sections 110_{A} via one of a plurality of U-shaped sections 112_{A} of the continuous internal conduit 104_{A}. The last one of the plurality of interconnected parallel sections 110a is connected to the liquid outlet 108_{A}.

The air-to-liquid heat exchanger 100_{B} is mounted to the air-to-liquid heat exchanger 100_{A} so that air having flowed through the air-to-liquid heat exchanger 100_{A} flows through the air-to-liquid heat exchanger 100_{B}. The air-to-liquid heat exchanger 100_{B} comprises a frame 102_{B}, a liquid inlet 106_{B} mounted to the frame 102_{B} and adapted to receive liquid from the same cold supply line or from another cold supply line, a liquid outlet 108_{B} mounted to the frame 102_{B} and adapted to return liquid to the same hot return line or to another hot return line, and a continuous internal conduit 104_{B} forming a plurality of interconnected parallel sections 110_{B} (only some are shown) extending within the frame 102_{B}.

The continuous internal conduit 104_{B} connects the liquid inlet 106_{B} to the liquid outlet 108_{B}. In more details, a one of the plurality of interconnected parallel sections 110_{B} is connected to the liquid inlet 106_{B}. Then, each one of the plurality of interconnected parallel sections 110_{B} except a last one is connected to a next one of the plurality of interconnected parallel sections 110_{B} via one of a plurality of U-shaped sections 112_{B} of the continuous internal conduit 104_{B}. The last one of the plurality of interconnected parallel sections 110₈ is connected to the liquid outlet 108_{B}. The air-to-liquid heat exchangers (100_{A}, 100_{B}) are assembled in an anti-parallel configuration in the sense that liquid flows in opposite directions in their respective liquid parallel sections (110_{A}, 110_{B}).

Figure 7 illustrates a particular configuration in which the liquid inlet 106_{A} and the liquid outlet 108_{A} are connected on opposite sides of the frame 102a, the continuous internal conduit 104_{A} forming an even number of interconnected parallel sections 110_{A} while the continuous internal conduit 104_{B} forms an even number of interconnected parallel sections 110_{B}. Likewise, the liquid inlet 106_{B} and the liquid outlet 108_{B} are connected on opposite sides of the frame 102_{B}. As illustrated, the interconnected parallel sections 110_{A} and 110_{B} extend horizontally. This is just one of many possible configurations. For instance, the interconnected parallel sections 110_{A} and 110_{B} may extend vertically. Some other configurations will be illustrated hereinbelow.

The air-to-liquid heat exchangers 100_{A} and 100_{B} are mounted to the server rack 10 so that the frame 102_{A} is parallel and adjacent to the frame 102_{B}. One of the plurality of interconnected parallel sections 110_{A} of the continuous internal conduit 104a nearest to the liquid inlet 106_{A} is proximate one of the plurality of interconnected parallel sections 110_{B} of the continuous internal conduit 104_{B} nearest to the liquid outlet 108_{B}. Otherwise stated, among the plurality of interconnected parallel sections 110_{A}, the one interconnected parallel section 110_{A} that is closest to the liquid inlet 106a is also the one interconnected parallel section 110_{A} that is closest to the one interconnected parallel section 110_{B} that is closest to the liquid outlet 108_{B}.

The one of the plurality of interconnected parallel sections 110_{A} of the continuous internal conduit 104_{A} nearest to the liquid inlet 106_{A} and the one of the plurality of interconnected parallel sections 110_{B} of the continuous internal conduit 104_{B} nearest to the liquid outlet 108_{B} may be directly facing each other when viewed in a general direction of an airflow expelled from the server rack 10. Alternatively, one of these parallel sections 110_{A} or 110_{B} may be positioned slightly higher or lower than the other. Precise placement of the one of the plurality of interconnected parallel sections 110_{A} of the continuous internal conduit 104_{A} nearest to the liquid inlet 106_{A} in relation to the proximate one of the plurality of interconnected parallel sections 110_{B} of the continuous internal conduit 104_{B} nearest to the liquid outlet 108_{B} may depend on the construction of the air-to-liquid heat exchangers 100_{A} and 100_{B} and on manufacturing tolerances. Minor variations on the placement of the parallel sections 110_{A} and 110_{B} within the cooling arrangement 300 are not expected to have a significant impact on the cooling performance.

Given any one of these configurations, a topmost strata of the airflow expelled from the server rack 10 flows within the air-to-liquid heat exchanger 100_{A} around its topmost interconnected parallel sections 110a in which the liquid flowing through the continuous internal conduit 104_{A} is coolest, being closest to the liquid inlet 106_{A}. The topmost strata of the airflow then flows within the air-to-liquid heat exchanger 100_{B} around its topmost interconnected parallel sections 110_{B} in which the liquid flowing through the continuous internal conduit 104_{B} is warmest, being closest to the liquid outlet 108_{B}. Conversely, a bottommost strata of the airflow expelled from the server rack 10 flows within the air-to-liquid heat exchanger 100_{A} around its bottommost interconnected parallel sections 110a in which the liquid flowing through the continuous internal conduit 104_{A} is warmest, being closest to the liquid outlet 108_{A}. The bottommost strata of the airflow then flows within the air-to-liquid heat exchanger 100_{B} around its bottommost interconnected parallel sections 110_{B} in which the liquid flowing through the continuous internal conduit 104_{B} is coolest, being closest to the liquid inlet 106_{B}. An equivalent result may be obtained by positioning the liquid inlet 106_{A} and the liquid outlet 108_{B} at the bottom of the cooling arrangement 300, also positioning the liquid outlet 108_{A} and the liquid inlet 106_{B} at the top of the cooling arrangement 300. Rotating the cooling arrangement 300 so that the interconnected parallel sections 110_{A} and 110_{B} extend vertically is also contemplated.

This effect is spread to all strata of the airflow, each of which gradually receive less cooling from the air-to-liquid heat exchanger 100_{A} along their distribution from the topmost strata toward the bottommost strata, gradually receiving more cooling from the air-to-liquid heat exchanger 100_{B} along the same distribution.

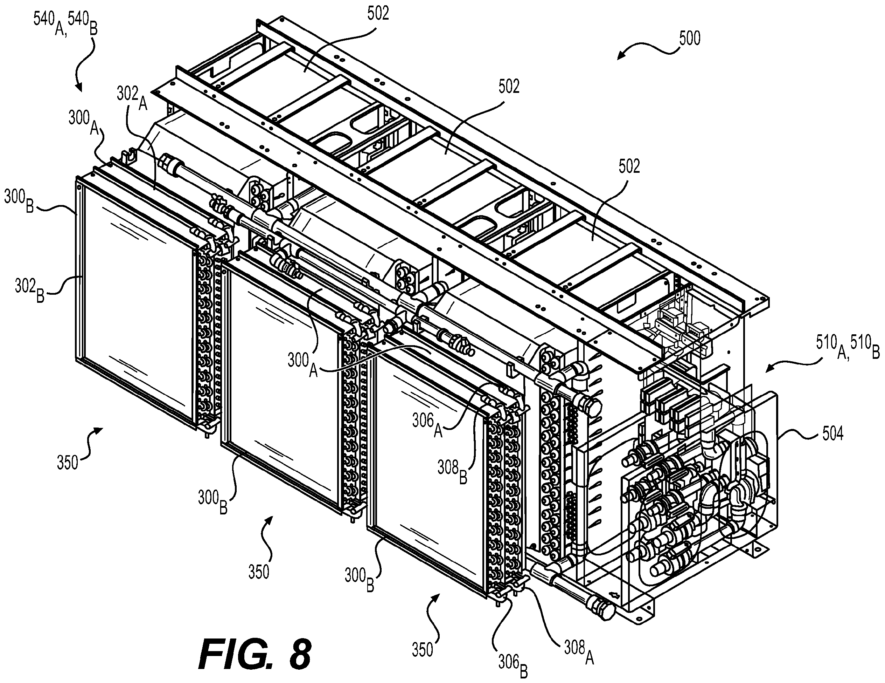

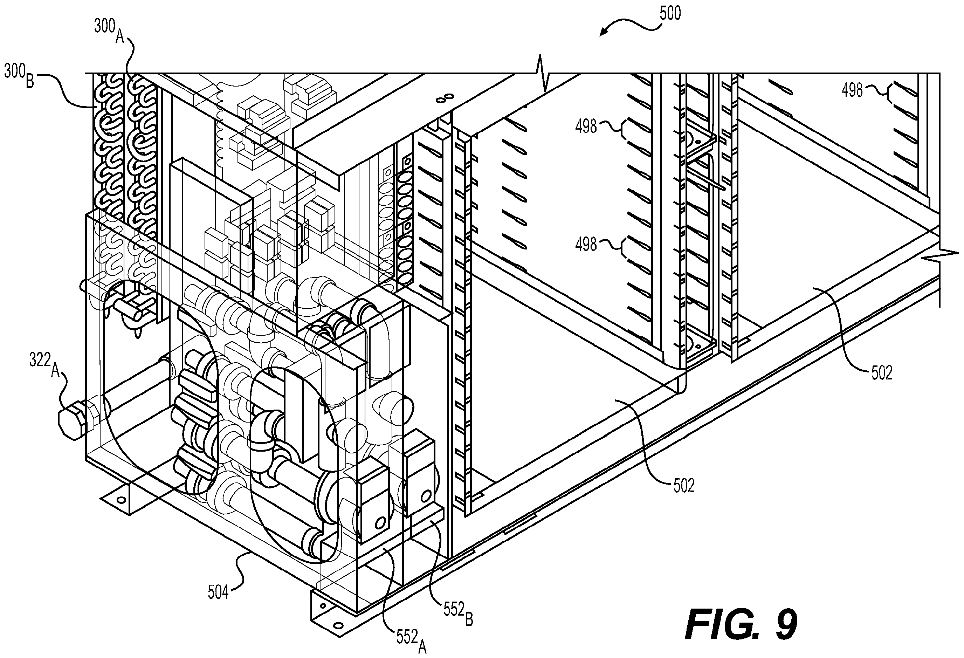

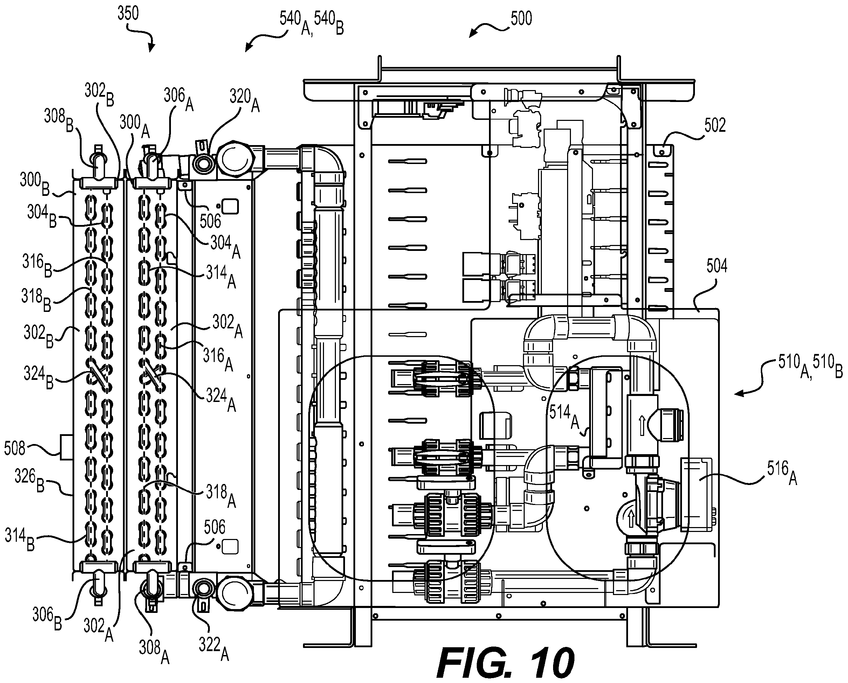

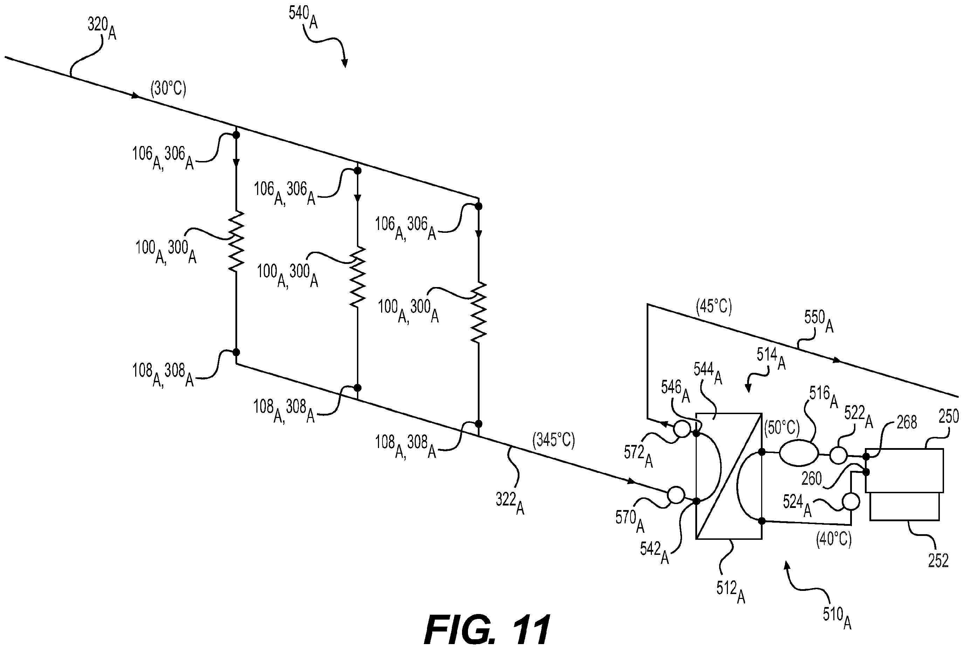

Figure 8 is a rear perspective view of a server rack having an autonomous and redundant cooling arrangement including a pair of closed loops and a pair of open loops in accordance with an embodiment of the present technology. Figure 9 is a partial, front perspective view of the server rack of Figure 8. Figure 10 is a side elevation view of the server rack of Figures 8 and 9 in accordance with an embodiment of the present technology. Figure 11 is a highly schematic illustration of a cooling arrangement having a closed loop including a liquid cooling unit and an open loop including air-to-liquid heat exchangers. A server rack 500 has a plurality of server housings 502 (three are shown), each of which includes at least one fan 12 (Figure 1). Each server housing 502 hosts a plurality of components 254, for example servers, network switches, power distribution units and other electric or electronic devices, mounted via the front of the server rack 500 in respective stages 498 of the server housings 502. One or more processors 252 or other heat-generating units, such as graphical processor units, random-access memory devices, hard disk drives, may be mounted on each component 254. A water block 250 or another cooling unit, for example a heat pipe, is mounted on each heat-generating unit. A cooling arrangement 350 is mounted on the rack 500. The cooling arrangement 350 provides autonomous cooling for the rack 500. In a datacenter, a plurality of cooling arrangements 350 may independently provide cooling for a plurality of corresponding racks 500.

The cooling arrangement 350 as shown comprises two closed loops 510_{A} and 510_{B} operatively and fluidly connected to two corresponding open loops 540a and 540_{B}. In Figures 8, 9 and 10, the rack 500 has a generally rectangular perimeter. Most components of the open loops 540a and 540_{B} are mounted on a rear side of the rack 500. Most components of the closed loops 510_{A} and 510_{B} are mounted in a subframe 504 mounted on a lateral side of the rack perpendicular to the rear side.

The cooling arrangement 350 includes two closed loops 510_{A} and 510_{B} and two open loops 540a and 540_{B} for redundancy purposes. Each pair comprising one closed loop 510_{A} or 510_{B} and one corresponding open loop 540_{A} or 540_{B} may provide sufficient cooling capacity to maintain all components 254 hosted in the rack 500 to less than a safe temperature threshold when the other closed loop and the other open loop are taken out of service, so to provide full and complete cooling redundancy for the rack 500. Cooling arrangements including only one closed loop and one open loop, or including two closed loops and only one open loop, or including one closed loop and two open loops, are also contemplated in applications where redundancy is a less important concern.

The two closed loops 510_{A} and 510_{B} are substantially identical and the closed loop 510_{A} will first be described. The closed loop 510_{A} comprises at least one liquid cooling unit, for example a water block 250, thermally coupled to a heat-generating unit, for example a processor 252 of at least one component 254, for example a server, mounted in the rack 500. Each water block 250 comprises a liquid channel 264 in which a liquid, for example water, flows. Heat generated by the processor 262 is transferred to the liquid flowing in the liquid channel 264. The closed loop 510_{A} comprises a primary side 512_{A} of a liquid-to-liquid heat exchanger 514a. In an embodiment, the liquid-to-liquid heat exchanger 514a is a plate heat exchanger. The primary side 512_{A} is fluidly connected to the liquid channel 264 of the at least water block 250. A pump 516_{A} is fluidly connected between the at least one water block 250 and the primary side 512_{A} of the liquid-to-liquid heat exchanger 514a. The pump 516a maintains a flow of the liquid circulating within the closed loop 510_{A}. Positioning the pump 516_{A} at the level of the subframe 504 for serving one rack 500 allows to easily manage a flow rate of the cooling liquid in the water blocks 250.

In more details, the primary side 512_{A} of the liquid-to-liquid heat exchanger 514a comprises a liquid inlet 518_{A} fluidly connected to the liquid outlet 268 of the water block 250, via the pump 516_{A}, and a liquid outlet 520_{A} fluidly connected to the liquid inlet 260 of the water block 250. As shown on Figure 6, the liquid channel 264 extends between the liquid inlet 260 and the liquid outlet 268 of the water block 250. A valve 522a is provided within the connection that extends from the liquid outlet 268 of the water block 250 to the pump 516_{A}. Another valve 524_{A} is provided within the connection that extends from the liquid outlet 520_{A} of the primary side 512_{A} to the liquid inlet 260 of the water block 250. The valves 522a and 524_{A} may be closed when it is desired to take the closed loop 510_{A} out of service, for example for maintenance purposes. The pump 516_{A} should be turned off when the valves 522a and 524_{A} are closed.

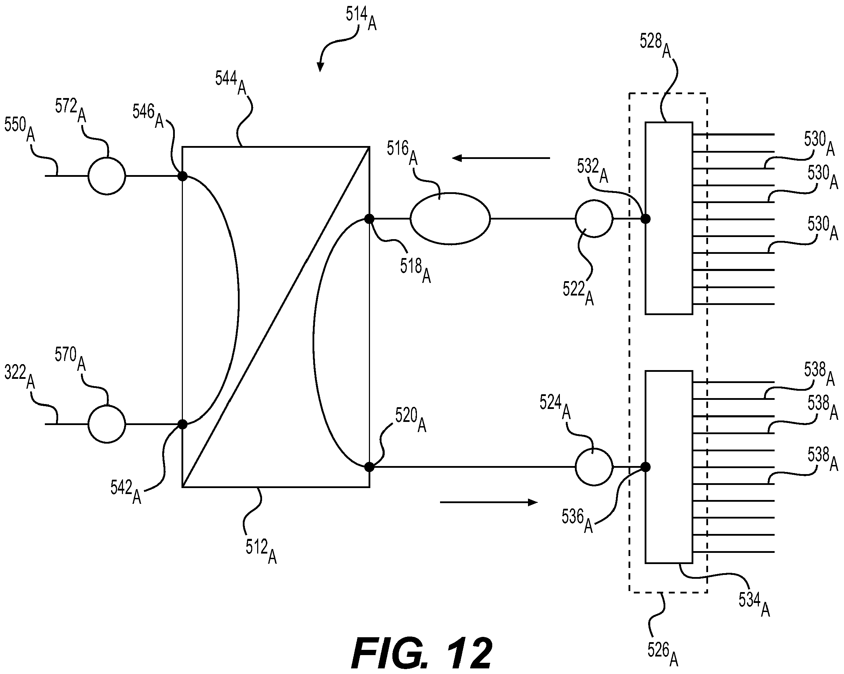

The primary side 512_{A} of the liquid-to-liquid heat exchanger 514a is connected to a plurality of water blocks 250 that are each thermally coupled to a corresponding processor 252 or other heat-generating unit. Figure 12 is a schematic block diagram of a manifold connection between a plurality of water blocks, a pump and a liquid-to-liquid heat exchanger. Within the closed loop 510_{A}, a manifold 526_{A} includes a multi-port inlet 528_{A} having a plurality of ports 530a connectable to the liquid outlets 268 of a plurality of water blocks 250 and one port 532_{A} connectable to the valve 522_{A} for delivering hot liquid from the water blocks 250 to the primary side 512_{A} of the liquid-to-liquid heat exchanger 514a via the pump 516_{A}. The manifold 526_{A} also includes a multi-port outlet 534_{A} having a port 536_{A} for receiving, via the valve 524a, liquid having been cooled by the liquid-to-liquid heat exchanger 514a. The multi-port outlet 534_{A} also includes a plurality of ports 538_{A} for delivering this liquid to the liquid inlets 260 of the water block 250.

The closed loop 510_{B} is constructed in the same manner as the closed loop 510_{A} and includes the same or equivalent components. Within the closed loop 510_{B}, a respective primary side of a respective liquid-to-liquid heat exchanger 514_{B}, for example another plate heat exchanger, is fluidly connected to the liquid inlet 258 and to the liquid outlet 270 of each water block 250, a respective pump 516_{B} ensuring a flow of liquid in the liquid channel 266 of each water block 250. Within the closed loop 510_{B}, the respective liquid-to-liquid heat exchanger 514_{B} comprises a liquid inlet and a liquid outlet as described hereinabove. The closed loop 510_{B} also comprises a respective manifold as present in the closed loop 510_{A}. Respective valves 522a and 524_{B} similar to those present in the closed loop 510_{A} may be closed when it is desired to take the closed loop 510_{B} out of service.

The first and second open loops 540a and 540_{B} as illustrated respectively comprise first and second dual-flow air-to-liquid heat exchangers 300_{A} and 300_{B}. These dual-flow air-to-liquid heat exchangers 300_{A} and 300_{B} represent a modest increase in size, particularly an increased thickness, when compared to the single-flow heat exchangers 100 used in the configuration of Figure 7. They however provide a large increase in cooling efficiency while remaining significantly thinner than the multi-flow air-to-liquid heat exchanger 200 of Figure 4. Although Figure 8 shows the dual-flow air-to-liquid heat exchangers 300_{A} and 300_{B}, mounting first and second single-flow heat exchangers 100_{A} and 100_{B} on the server rack 500, as a part of the cooling arrangement 350, is also contemplated.

The fan or fans 12 contained within each server housing 502 provide forced air cooling to the equipment mounted in the server housings 502 and generate an airflow directed toward the corresponding pair of dual-flow air-to-liquid heat exchangers 300_{A} and 300_{B}. Each one of the first and second dual-flow air-to-liquid heat exchangers 300_{A} and 300_{B} may be configured for reducing a temperature of the air expelled from the corresponding server housing 502 to less than a maximum rated air temperature to maintain a safe operating temperature of the corresponding server housing 502 on which it is mounted when the other one of the first and second dual-flow air-to-liquid heat exchangers 300_{A} and 300_{B} is taken out of service for maintenance or as a result from an equipment failure. Redundancy of the forced air cooling may be obtained by providing at least two fans 12 in each server housing 502, the at least two fans 12 receiving electrical power from two distinct electrical sources.

Figure 10 also shows that the air-to-liquid heat exchangers 300_{A}, 300_{B} are mounted on the server rack 500 by use of a pair of hinges 506 mounted on a lateral side of the first frame 302_{A}, the hinges 506 being adapted for pivotally mounting the air-to-liquid heat exchangers 300_{A}, 300_{B} on the rack 10. Optionally, additional hinges may be installed between the two hinges 506 as shown. The particular configuration of Figure 10 shows that the hinges 506 are located on the same side of the air-to-liquid heat exchangers 300_{A}, 300_{B} where the liquid inlets 306_{A}, 306_{B} and the liquid outlets 308_{A}, 308_{B} are also located. This configuration facilitates pivoting of the air-to-liquid heat exchangers 300_{A}, 300_{B} about the hinges 506. Mounting the cooling arrangement 300 of Figure 7 on a rack using the hinges 506 is also contemplated. It may be noted that, in some implementations the fans 12 installed in each server housing may be mounted on a fan plate (not shown) physically connected to the server rack 500 by use of additional hinges (not shown) that may be located on a same side as the hinges 506 or on an opposite side. When the hinges of the fan plate and the hinges 506 are on the same side and share a common pivot axis, the fan plate and the air-to-liquid heat exchangers 300_{A}, 300_{B} may be configured to rotate independently or as a single block. Mounting the air-to-liquid heat exchangers 300_{A}, 300_{B} on the rack 500 using the hinges 506 allows access to the fans 12 for maintenance purposes. Rotating the fan plate in this manner may be useful in providing access to network connectivity devices, hard disk drives, electrical connections and hydraulic connections within the rack 500.

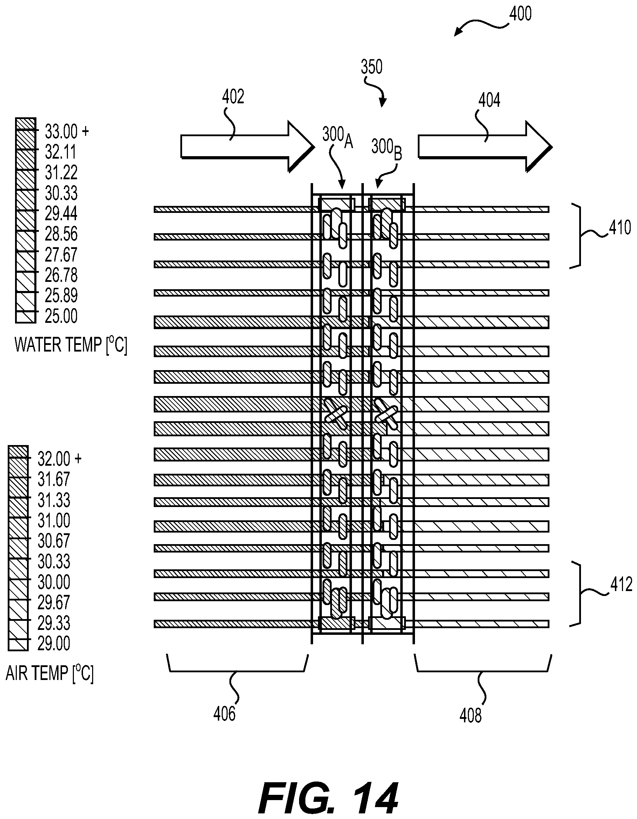

Also shown on Figure 10 is a temperature sensor 508 mounted on an external face 326_{B} of the dual-flow second air-to-liquid heat exchanger 300_{B}. The temperature sensor 508 may measure and transmit a temperature of air having flowed through the first and second dual-flow air-to-liquid heat exchangers 300_{A}, 300_{B} to a remote monitoring device (not shown). The server rack 500 may comprise a plurality of additional sensors (not shown) for providing various temperature, liquid flow, and pressure measurements to the remote monitoring device, the temperature sensor 508 and these additional sensors sharing a common communication link (not shown) for forwarding their measurements to the remote monitoring device. A position of the temperature sensor 508 on the external face 326_{B} of the second dual-flow air-to-liquid heat exchanger 300_{B} may vary horizontally and/or vertically, given that the temperature of the air having flowed through the first and second dual-flow air-to-liquid heat exchangers 300_{A}, 300_{B} substantially homogeneous, as will be illustrated on Figure 14. Mounting the temperature sensor 508 on an external face of the second air-to-liquid heat exchanger 100_{B} of the cooling arrangement 300 is also contemplated.

On Figures 8 and 10, a liquid inlet 306a and a liquid outlet 308_{A} are connected on a same side of a frame 302_{A}, and a liquid inlet 306_{B} and a liquid outlet 308_{B} are connected on a same side of the frame 302_{B}. Additionally, the liquid inlets 306a and 306_{B} are located on a same side of the cooling arrangement 350. An alternate configuration in which the liquid inlets 306a and 306_{B} are located on opposite sides of the cooling arrangement 350 is also contemplated.

As best seen on Figure 10, in a particular non-limiting configuration, the first dual-flow air-to-liquid heat exchanger 300a comprises a first continuous internal conduit 304_{A} forming a first plurality of interconnected parallel sections (not shown) and a third continuous internal conduit 314_{A} forming a third plurality of interconnected parallel sections (not shown). The first and third pluralities of interconnected parallel sections extend within the first frame 302_{A}. The first and third continuous internal conduits 304_{A} and 314_{A} connect the first liquid inlet 306_{A} to the first liquid outlet 308_{A}. Likewise, the second dual-flow air-to-liquid heat exchanger 300_{B} comprises a second continuous internal conduit 304_{B} forming a second plurality of interconnected parallel sections (not shown) and a fourth continuous internal conduit 314_{B} forming a fourth plurality of interconnected parallel sections (not shown), the second and fourth pluralities of interconnected parallel sections extending within the second frame 302_{B}. The second and fourth continuous internal conduits 304_{B} and 314_{B} connect the second liquid inlet 306_{B} to the second liquid outlet 308_{B}.

As illustrated, a first portion of the first plurality of interconnected parallel sections is located in a first plane 316_{A} within the first frame 302a and a second portion of the first plurality of interconnected parallel sections is located in a second plane 318_{A} within the first frame 302_{A}, the second plane 318_{A} being parallel to the first plane 316a. Conversely, a first portion of the third plurality of interconnected parallel sections is located in the second plane 318_{A} within the first frame 302a and a second portion of the third plurality of interconnected parallel sections is located in the first plane 316_{A} within the first frame 302_{A}. The third continuous internal conduit 314_{A} and the first continuous internal conduit 304_{A}, both change between the first plane 316a and the second plane 318_{A} at a crossing point 324_{A}. Variants of the first dual-flow air-to-liquid heat exchanger 300a may include one or more crossing points 324_{A} and may alternatively have no such crossing point.

Likewise, a first portion of the second plurality of interconnected parallel sections is located in a third plane 316_{B} within the second frame 302_{B} and a second portion of the second plurality of interconnected parallel sections is located in a fourth plane 318_{B} within the second frame 302_{B}, the fourth plane 318_{B} being parallel to the third plane 316_{B}. Conversely, a first portion of the fourth plurality of interconnected parallel sections is located in the fourth plane 318_{B} within the second frame 302_{B} and a second portion of the fourth plurality of interconnected parallel sections is located in the third plane 316_{B} within the second frame 302_{B}. The fourth continuous internal conduit 314_{B} and the second continuous internal conduit 304_{B}, both change between the third plane 316_{B} and the fourth plane 318_{B} at a crossing point 324_{B}. Variants of the second dual-flow air-to-liquid heat exchanger 300_{B} may include one or more crossing points 324_{B} and may alternatively have no such crossing point. The first and second dual-flow air-to-liquid heat exchangers 300_{A}, 300_{B} of the cooling arrangement 350 may have different numbers of crossing points 324_{A} or 324_{B}.

In the open loop 540_{A}, the air-to-liquid heat exchanger 300a is fed via a cold supply line 320_{A} with cold liquid from an external source to reduce a temperature of the air expelled from the rack 500 by the fans 12. The air-to-liquid heat exchanger 300_{B} in the open loop 540_{B} is either fed by the cold supply line 320a or by another cold supply line (not shown). A temperature of the liquid flowing out of the liquid outlets 308_{A} and 308_{B} is modestly increased by the transfer of heat from the air expelled from the server rack 500; for explanation purposes, the liquid flowing out of the open loops 540a and 540_{B} may be characterized as a 'warm' liquid. In contrast, the liquid flowing out of the water blocks 250 has a considerably higher temperature. As a result, the warm liquid at the output of the open loops 540a and 540_{B} is used to provide cooling to the closed loops 510_{A} and 510_{B}. To this end, the closed loops 510_{A} and 510_{B} are respectively thermally connected to the open loops 540a and 540_{B}.

As best seen on Figure 10, the liquid inlet 306a of each air-to-liquid heat exchanger 300a is connected to the first cold supply line 320a and the liquid outlet 308_{A} of the air-to-liquid heat exchanger 300a is connected to a first warm liquid line 322_{A}. Although not shown, the liquid inlet 306_{B} of air-to-liquid heat exchanger 300_{B} are connected to the first cold supply line 320a or to another cold supply line (not shown). The liquid outlet 308_{B} of air-to-liquid heat exchanger 300_{B} is connected to a second warm liquid line (not shown) similar to the first warm liquid line 322_{A}. As shown on Figure 11, the first and second warm liquid lines respectively deliver the warm liquid from the liquid outlets 308_{A} and 308_{B} to secondary sides of the liquid-to-liquid heat exchangers 514a and 514_{B}. The first warm liquid line 322_{A} is fluidly connected via a valve 570_{A} to a liquid inlet 542_{A} of a secondary side 544_{A} of the liquid-to-liquid heat exchanger 514a.

The primary side 512a and the secondary side 544_{A} of the liquid-to-liquid heat exchanger 514a are thermally coupled for transfer of heat from the primary side 512_{A} to the secondary side 544_{A} when a temperature of the first primary side 512_{A} is higher than a temperature of the secondary side 544_{A}. In operation, the primary side 512_{A} receives the hot liquid from one or more water blocks 250 and its temperature is significantly higher than that of the warm liquid received in the secondary side 544_{A}. Therefore, the liquid-to-liquid heat exchanger 514_{A} transfers heat from its primary side 512_{A} to the secondary side 544_{A}. The warm liquid received at the liquid inlet 542_{A} of the secondary side 544_{A} is heated before being expelled from the secondary side 544_{A} via a liquid outlet 546_{A}. The heated liquid flows from the liquid outlet 546_{A} via a valve 572_{A} and leaves the open loop 540_{A} via a hot return line 550_{A}. The open loop 540_{A} may be taken out of service by closing the valves 570a and 572_{A}. The open loop 540_{B} is constructed in the same manner; it can also be taken out of service by closing valves 570_{B} and 572_{B}. It may be noted that the air-to-liquid heat exchangers 300a may be substituted with the air-to-liquid heat exchangers 100_{A}; the same is true for the air-to-liquid heat exchangers 300_{B} that may be substituted with the air-to-liquid heat exchangers 100_{B}. For example and without limitation, in the open loop 540_{A}, water may be received on the cold supply line 320a at 30 degrees. The water is heated by the dual-flow air-liquid heat exchangers 300a to a temperature of 34.5 degrees in the first warm liquid line 322_{A}. In the same example, water is supplied by the primary side 512_{A} of the liquid-to-liquid heat exchanger 514_{A} to the water blocks 250 at 40 degrees, the water reaching a temperature of 50 degrees when returning to the primary side 512_{A}. Thermal exchange from the primary side 512a to the secondary side 544_{A} of the liquid-to-liquid heat exchanger 514a causes the water in the open loop 540a to reach a temperature of 45 degrees in the hot return line 550_{A} while causing the water in the closed loop 510_{A} to reach the above-mentioned temperature of 40 degrees at the liquid inlet 518_{A} of the primary side 512a. It may be noted that, in cold climates, the high temperature of the liquid flowing in the hot return line 550_{A} could be considered for heat recovery purposes.

Although not shown on Figure 11, two distinct pumps may be mounted in series for redundancy and/or for increasing the flow of the liquid circulating within the closed loop 510_{A}. Likewise, two liquid-to-liquid heat exchangers may be mounted so that their primary sides are connected in series or in parallel within the closed loop 510_{A} and so that their secondary sides are connected in series or in parallel within the open loop 540a. The use of two liquid-to-liquid heat exchangers allows extracting more thermal energy from the water blocks 250 within the closed loop 510_{A}.

Also not shown on Figure 11, the closed loop 510_{B} and the open loop 540_{B} are connected in a similar manner as expressed in the discussion of the closed loop 510_{A} and the open loop 540a. The heated liquid flowing from the liquid outlet of the secondary side of the liquid-to-liquid heat exchanger 514_{B}, at the junction of the closed loop 510_{B} and the open loop 540_{B}, may leaves the cooling arrangement via the hot return line 550_{A} or via another hot return line. It may be noted that although the above description of Figures 8-11 indicates that the open loop 510A a is only connected to the closed loop 510_{A} and that the open loop 540_{B} is only connected to the closed loop 510_{B}, other configurations are also contemplated. For example and without limitation, the liquid outlets 308_{A} and 308_{B} of the air-to-liquid heat exchangers 300_{A} and 300_{B} could all be connected to common same warm liquid line 322_{A} feeding both secondary sides of the liquid-to-liquid heat exchangers 514a and 514_{B}. Configurations having distinct numbers of open loops and distinct numbers of closed loops are also contemplated; in an example, the number of open loops may differ from the number of closed loops.

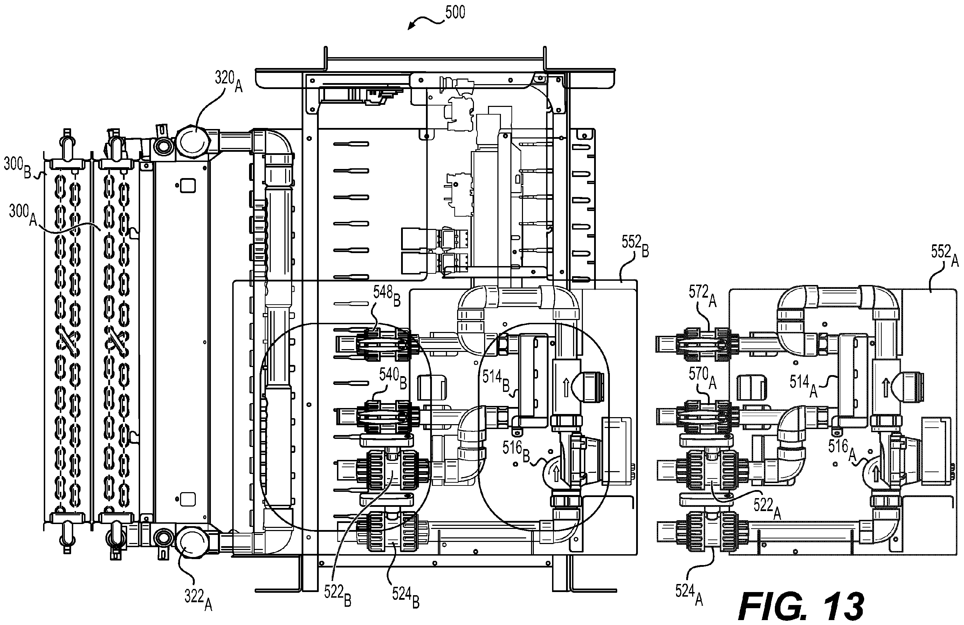

In the non-limiting configuration of Figures 8, 9 and 10, the liquid-to-liquid heat exchangers, the pumps and the valves included in the closed loops, the valves in fluidic connection between the air-to-liquid heat exchangers and the liquid-to-liquid heat exchangers are all located within the subframe 504. Figure 13 is another side elevation view of the server rack of Figures 8 and 9 showing a removal of a module in accordance with an embodiment of the present technology. The components contained in the subframe 504 are grouped in two modules 552a and 552_{B}. The module 552_{A} contains the liquid-to-liquid heat exchanger 514_{A}, the pump 516_{A}, the valves 522a, 524_{A}, 570_{A} and 572_{A}, and tubing connection these various components. The module 552_{B} contains the liquid-to-liquid heat exchanger 514_{B}, the pump 516_{B}, the valves 522_{B}, 524_{B}, 570_{B} and 572_{B}, and tubing connection these various components. When all valves contained in one of the modules 552_{A} or 552_{B} are closed, and as the corresponding pump 516_{A} or 516_{B} is turned off, that module 552_{A} or 552_{B} may be removed from the subframe 504 for maintenance purposes, as shown on Figure 13. It may be noted that, in some embodiments, the valves 522a, 524_{A}, 570_{A} and 572_{A} (resp. 522_{B}, 524_{B}, 570_{B} and 572_{B}) are fixed parts of the tubing connections beyond the module 552_{A} (resp. 552_{B}), and in this case, the module 552_{A} (resp. 552_{B}) should be drained from its liquid before it may be removed from the subframe 504.

Various examples may comprise the inclusion of additional redundant components for enhanced cooling reliability. For example, in a non-limiting example, the liquid-to-liquid heat exchanger 514_{A} (resp. 514_{B}) of the module 552_{A} (resp. 552_{B}) may be replaced by two liquid-to-liquid heat exchangers 514_{A} (resp. 514_{B}) fluidly connected either in series or in parallel configurations. In the same or another the pump 516_{A} (resp. 516_{B}) of the module 552_{A} (resp. 552_{B}) may be replaced by a pair of two pumps 516_{A} (resp. 516_{B}) fluidly connected in series. The pumps of the pair may be electrically connected to distinct and independent electrical sources for redundancy purposes. One pump of the pair may run while the other is off. In the same or another example, each valve 522a, 524_{A}, 570_{A} and 572_{A} (resp. 522_{B}, 524_{B}, 570_{B} and 572_{B}) may be replaced by a pair of valves fluidly connected in series for security purposes, a first valve of each pair belonging to the module 552_{A} (resp. 552_{B}), a second valve of the pair staying attached to the piping beyond the first valve. In the same or another example, the modules 552a and 552_{B} may be connected to the same closed loop 510_{A} and to the same open loop 540_{A} by means of T-piping elements located outside the modules 552a and 552_{B}. In such an example, the two modules 552a and 552_{B} may be fluidly connected in parallel regarding the closed loop 510_{A} and the open loop 540a. Finally, in the same or another example, a same liquid may be used in the closed loops 510_{A} and 510_{B} and in the open loops 540_{A} and 540_{B}, for example water. In such an example, the closed loop 510_{A} (resp. 510_{B}) may initially be filled in liquid using a pressure regulator (not shown) installed in the module 552_{A} (resp. 552_{B}) and connected between the closed loop 510_{A} (resp. 510_{B}) and the open loop 540_{A} (resp. 540_{B}). The open loops 540_{A} and 540_{B} may thus become a liquid source for the closed loops 510_{A} and 510_{B} when needed. In a similar way, a pressure relief valve (not shown) may be installed in the module 552_{A} (resp. 552_{B}) and connected between the closed loop 510_{A} (resp. 510_{B}) and the open loop 540_{A} (resp. 540_{B}). In case of an excessive pressure in the closed loop 510_{A} (resp. 510_{B}), the liquid may be expelled into the open loop 540_{A} (resp. 540_{B}). It may be noted that other piping elements may be present in the modules 552a and 552_{B}. Though not shown in the different Figures, filters may be disposed in various piping, check valves may be placed after the pumps 516_{A} and 516_{B}, and expansion tanks may be used to attenuate variations of pressure in the closed loops 510_{A} and 510_{B}.

One or two external pumps of one or two pumping substations (not shown) provide a continuous flow of cold liquid delivered to the cooling arrangement 350 via the cold supply line or lines 320a and 320_{B}, and retrieve heated liquid from the cooling arrangement 350 via the hot return line or lines. The external pumps ensure a continuous flow of the liquid between the cooling arrangement 350 and a cold outlet and a hot inlet of further cooling equipment, for example a dry cooler (not shown), located outside of the data center.

Figure 14 is a visual representation of a homogeneous temperature pattern of an airflow expelled from dual-flow air-liquid heat exchangers assembled in an anti-parallel configuration. A diagram 400 illustrates a temperature of a flow of air determined in a simulation environment, before and after passing through the cooling arrangement 350. The air flows in the direction of arrows 402 and 404. In a first zone 406 upstream of the cooling arrangement 350, a temperature of the airflow is high due to the generation of heat in the server rack 10, being for example at about 40 degrees. The temperature of the airflow is substantially uniform within the first zone 406. Cold water is received at the top of the first dual-flow air-liquid heat exchanger 300_{A}, at a temperature of about 25 degrees. Upper strata 410 of the air flowing downstream of the first dual-flow air-liquid heat exchanger 300a are cooled to about 30 degrees. A temperature of the water flowing through the first dual-flow air-liquid heat exchanger 300_{A} increases as it passes through the various interconnected parallel sections 110_{A}, being continuously exposed to the 40 degrees airflow. The water reaches about 33 degrees the bottom of the first dual-flow air-liquid heat exchanger 300_{A}. Consequently, the airflow between the first and second dual-flow air-liquid heat exchangers 300_{A}, 300_{B} has a stratified, heterogeneous temperature profile in which lower strata 412 of the air flowing downstream of the first dual-flow air-liquid heat exchanger 300a are only cooled to about 37 degrees.

The same airflow immediately reaches the second dual-flow air-liquid heat exchanger 300_{B}. Cold water is received at the bottom of the second dual-flow air-liquid heat exchanger 300_{B}, also at a temperature of about 25 degrees. Lower strata 412 of the airflow, which have been cooled to a limited extent to about 37 degrees when flowing through the dual-flow first air-liquid heat exchanger 300_{A}, receive maximum cooling from the dual-flow second air-liquid heat exchanger 300_{B} and reach a temperature of about 30 degrees. Upper strata 410 of the airflow, which have been cooled to a larger extent to about 30 degrees when flowing through the first dual-flow air-liquid heat exchanger 300a, receive a modest level of cooling from the second dual-flow air-liquid heat exchanger 300_{B} to also reach a temperature of about 29 degrees. As a result, the same airflow having passed through the second dual-flow air-liquid heat exchanger 300_{B} has a substantially homogeneous temperature profile and all strata of the airflow expelled from the cooling arrangement 350 in a zone 408 are at a substantially uniform temperature of about 30 degrees. The water also reaches about 29 degrees the top of the second dual-flow air-liquid heat exchanger 300_{B}.

Referring again to Figure 3, the diagram 150 illustrates results obtained when using the single-flow heat exchanger 100. In contrast, the diagram 400 illustrates results obtained when using a pair of dual-flow heat exchangers 300_{A}, 300_{B}. These results are not directly comparable due to the respective cooling capacities of these different heat exchangers. However, while the numerical absolute temperature values shown on Figures 3 and 14 cannot be directly compared, the difference in the airflow temperature patterns is striking: while Figure 3 shows an important stratification of the temperature pattern, Figure 14 shows uniformity and homogeneity of the temperature in all strata of the airflow expelled from the cooling arrangement 350. It may be noted that using a pair of single-flow heat exchangers mounted in anti-parallel fashion would arguably produce a lesser decrease of the airflow temperature, but would nevertheless provide homogeneity of the temperature in all strata of the resulting airflow. In contrast, using a single dual-flow heat exchanger would still result in a stratified, heterogeneous temperature profile of the resulting airflow.

In summary, the cooling configuration illustrated on the various view of Figures 8 to 12 fluidly connects in series the air-to-liquid heat exchangers 100_{A} and 100_{B}, or 300_{A} and 300_{B}, of the rack 500 to the secondary sides of the liquid-to-liquid heat exchangers 514a and 514_{B} mounted to the same rack 500. This configuration may be compared to a more traditional cooling arrangement in which the cooling needs of a plurality of racks are served by larger components, including a dedicated pumping substation for air-to-liquid heat exchangers, further outside cooling equipment (e.g. dry coolers), further including dedicated pumping sub-stations for liquid cooling within the racks, and large liquid-to-liquid heat exchangers.

Experimentations were made using the present cooling configuration, in which water was used as a cooling liquid. These experimentations have shown a 50% reduction of a number of piping lines within a data center. As illustrated in the example of Figure 11, a temperature difference between the cold supply line 320a and the hot return line 550_{A} was equal to about 15 degrees, which compares to a typical difference of about 5 degrees obtained using a conventional configuration and is indicative of a far better heat transfer performance. Given this increase of the temperature gradient between the cold supply line 320a and the hot return line 550_{A}, the flow of water required to cool the rack 500 was reduced so the nominal diameter of the cold supply line 320a and of the hot return line 550_{A} was reduced from 4 inches to 2.5 inches. The thermal efficiency of dry coolers used as external cooling units receiving the return water from the hot return line 550_{A} and returning cold water via the cold supply line 320a was increased by more than 33% and it was possible to operate such dry coolers without adding any evaporative cooling A total number of pumping stations was reduced by 25%. Capital expenses required to provide the same cooling capacity as when using a conventional configuration were reduced by 25%, despite the fact that traditional polyvinyl chloride (PVC) piping was replaced with stainless steel and copper piping for enhanced reliability. Operating expenses in terms of electrical power required to drive various pumps and fans was reduced by more than 50%.

The present technology is amenable to implementations in data centers and other computing facilities in which various racks having distinct ratios of air-cooling and liquid-cooling capabilities. In many implementations, impacts of eventual cooling equipment failures are constrained to a single rack and are limited by the redundancy of many components.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

It should be expressly understood that not all technical effects mentioned herein need to be enjoyed in each and every embodiment of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A cooling arrangement (350) for autonomous cooling of a rack (500) hosting a plurality of components (254), each of the plurality of components comprising one or more heat-generating units (252), and at least one fan (12), wherein the cooling arrangement comprises:
a first closed loop (510_{A}) comprising:
a plurality of liquid cooling units (250), each of the plurality of liquid cooling units (250) being thermally coupled to a corresponding one of the one or more heat-generating units of each of the plurality of components, each of the plurality of liquid cooling units (250) comprising a first liquid channel (264) adapted for transferring heat from the corresponding one of the one or more heat-generating units of each of the plurality of components to a first liquid flowing in the first liquid channel, the first liquid channel (264) of each of the plurality of liquid cooling units extending between a first liquid inlet (256) and a first liquid outlet (268) of the corresponding one of the plurality of liquid cooling units,
a first primary side (512_{A}) of a first liquid-to-liquid heat exchanger (514_{A}) comprising a second liquid inlet (518_{A}) and a second liquid outlet (520_{A}), the first primary side being fluidly connected, via a first multi-port inlet (528_{A}) and a first multi-port outlet (534_{A}) of a first manifold (526_{A}), to the first liquid channel of each of the plurality of liquid cooling units (250), the first multi-port inlet (528_{A}) having a plurality of ports (530_{A}) fluidly connected to the first liquid outlets (268) of the plurality of liquid cooling units (250) and the first multi-port inlet (528_{A}) having one port (532_{A}) for delivering hot liquid from the liquid cooling units (250) to the second liquid inlet (518_{A}) on the first primary side (512_{A}) of the first liquid-to-liquid heat exchanger (514_{A}), and the first multi-port outlet (534_{A}) having one port (536_{A}) for receiving liquid, having been cooled by the liquid-to-liquid heat exchanger (514_{A}), from the second liquid outlet (520_{A}) on the first primary side (512_{A}) of the first liquid-to-liquid heat exchanger (514_{A}) and the multi-port outlet (534_{A}) also includes a plurality of ports (538_{A}) for delivering this liquid to the first liquid inlets (260) of the liquid cooling units (250),
and a first pump (516_{A}) fluidly connected between the second liquid inlet (518_{A}) and the one port (532_{A}) of the first multi-port inlet (528_{A}), or fluidly connected between the second liquid outlet (520_{A}) and the one port (536_{A}) of the first multi-port outlet (534_{A}), the first pump being adapted for causing the first liquid to flow within the first closed loop;
a first open loop (540_{A}) comprising:
a first air-to-liquid heat exchanger (100_{A}, 300_{A}) mounted to the rack so that heated air expelled from the rack by the at least one fan flows through the first air-to-liquid heat exchanger, the first air-to-liquid heat exchanger comprising a third liquid inlet (106_{A}, 300_{A}) adapted to receive a second liquid from a first cold supply line (320a), the first air-to-liquid heat exchanger further comprising a third liquid outlet (108_{A}, 308_{A}), and
a first secondary side (544_{A}) of the first liquid-to-liquid heat exchanger, the first secondary side being thermally coupled to the first primary side for transfer of heat from the first primary side to the first secondary side when a temperature of the first primary side is higher than a temperature of the first secondary side, the first secondary side being fluidly connected to the first air-to-liquid heat exchanger, the first secondary side comprising a fourth liquid inlet (542_{A}) fluidly connected to the third liquid outlet of the first air-to-liquid heat exchanger, and being adapted for receiving the second liquid from the third liquid outlet of the first air-to-liquid heat exchanger (100_{A}, 300_{A}) and the first secondary side (544_{A}) comprising a fourth liquid outlet (546_{A}) adapted for returning the second liquid to a first hot return line (550_{A}); wherein the rack has a generally rectangular perimeter, the first air-to-liquid heat exchanger being positioned on a first side of the rack, the cooling arrangement further comprising a subframe (504) mounted on a second side of the rack perpendicular to the first side, the subframe being configured to receive the first liquid-to-liquid heat exchanger and the first pump.

2. The cooling arrangement of claim 1, wherein the first cold supply line (320_{A}) is adapted for being connected to a cold outlet of a dry cooler and the first hot return line (550_{A}) is adapted for being connected to a hot inlet of the dry cooler.

3. The cooling arrangement of claim 1 or 2, wherein:
the first pump is connected to the second liquid inlet of the first primary side of the first liquid-to-liquid heat exchanger; and
the subframe is further configured to receive:
a first valve (522_{A}) within a connection extending from the first liquid outlet of each of the plurality of liquid cooling units to the first pump;
a second valve (524_{A}) within a fluid connection extending from the second liquid outlet of the first primary side of the first liquid-to-liquid heat exchanger to the first liquid inlet of each of the plurality of liquid cooling units;
a third valve (570_{A}) within a fluid connection extending from the third liquid outlet of the first air-to-liquid heat exchanger to the fourth liquid inlet of the first secondary side of the first liquid-to-liquid heat exchanger; and
a fourth valve (572_{A}) within a fluid connection extending from the fourth liquid outlet of the first secondary side of the first liquid-to-liquid heat exchanger to the first hot return line.

4. The cooling arrangement of claim 1 or 2, wherein:
each of the plurality of liquid cooling unit comprises a second liquid channel (266) adapted for transferring heat from the corresponding one of the plurality of heat-generating units to a third liquid flowing in the second liquid channel;
the cooling arrangement further comprises a second closed loop (540_{B}) comprising:
a second primary side of a second liquid-to-liquid heat exchanger (514_{B}), the second primary being fluidly connected, via a second multi-port inlet and a second multi-port outlet of a second manifold, to each channel, and
a second pump (516_{B}) fluidly connected between the second primary side of the second liquid-to-liquid heat exchanger and one of the second multi-port inlet and the second multi-port outlet, the second pump being adapted for causing the third liquid to flow within the second closed loop; and
the cooling arrangement further comprises a second open loop (540_{B}) comprising:
a second air-to-liquid heat exchanger (100_{B}, 300_{B}) mounted to the rack so that air having flowed through the first air-liquid heat exchanger flows through the second air-to-liquid heat exchanger, the second air-to-liquid heat exchanger being adapted to receive a fourth liquid from the first cold supply line or from a second cold supply line, and
a second secondary side of the second liquid-to-liquid heat exchanger, the second secondary side being thermally coupled to the second primary side for transfer of heat from the second primary side to the second secondary side when a temperature of the second primary side is higher than a temperature of the second secondary side, the second secondary side being fluidly connected to the second air-to-liquid heat exchanger, the second secondary side being adapted for returning the fourth liquid to the first hot return line (550_{A}) or to a second hot return line.

5. The cooling arrangement of claim 4, wherein:
each second liquid channel extends between a fifth liquid inlet (258) and a fifth liquid outlet (270) of the corresponding one of the plurality of liquid cooling units;
the second primary side of the second liquid-to-liquid heat exchanger comprises a sixth liquid inlet fluidly connected, via the second multi-port inlet, to the fifth liquid outlet of each of the plurality of liquid cooling units, the second primary side further comprising a sixth liquid outlet fluidly connected, via the second multi-port outlet, to the fifth liquid inlet of each of the plurality of liquid cooling units;
the second air-to-liquid heat exchanger comprises a seventh liquid inlet (106_{B}, 306_{B}) adapted to receive the fourth liquid from the first cold supply line or from the second cold supply line, the second air-to-liquid heat exchanger further comprising a seventh liquid outlet (108_{B}, 308_{B}); and
the second secondary side of the second liquid-to-liquid heat exchanger comprises an eighth liquid inlet fluidly connected to the seventh liquid outlet of the second first air-to-liquid heat exchanger and an eighth liquid outlet adapted for returning the second liquid to the first hot return line or to the second hot return line.

6. The cooling arrangement of claim 5, wherein the subframe is configured to receive:
a first module comprising:
the first liquid-to-liquid heat exchanger;
the first pump being connected to the second liquid inlet of the first primary side of the first liquid-to-liquid heat exchanger;
a first valve (522_{A}) within a connection extending from the first liquid outlet of each of the plurality of liquid cooling units to the first pump;
a second valve (524_{A}) within a fluid connection extending from the second liquid outlet of the first primary side of the first liquid-to-liquid heat exchanger to the first liquid inlet of each of the plurality of liquid cooling units;
a third valve (570_{A}) within a fluid connection extending from the third liquid outlet of the first air-to-liquid heat exchanger to the fourth liquid inlet of the first secondary side of the first liquid-to-liquid heat exchanger; and
a fourth valve (572_{A}) within a fluid connection extending from the fourth liquid outlet of the first secondary side of the first liquid-to-liquid heat exchanger to the first hot return line; and
a second module comprising:
the second liquid-to-liquid heat exchanger;
the second pump being connected to the sixth liquid inlet of the second primary side of the second liquid-to-liquid heat exchanger;
a fifth valve (522_{B}) within a connection extending from the fifth liquid outlet of each of the plurality of liquid cooling units to the second pump;
a sixth valve (524_{B}) within a fluid connection extending from the sixth liquid outlet of the second primary side of the second liquid-to-liquid heat exchanger to the fifth liquid inlet of each of the plurality of liquid cooling units;
a seventh valve (570_{B}) within a fluid connection extending from the seventh liquid outlet of the second air-to-liquid heat exchanger to the eighth liquid inlet of the second secondary side of the second liquid-to-liquid heat exchanger; and
an eighth valve (572_{B}) within a fluid connection extending from the eighth liquid outlet of the second secondary side of the second liquid-to-liquid heat exchanger to the first hot return line or to the second hot return line.

7. The cooling arrangement of claim 6, wherein:
the first closed loop and the first open loop are taken out of service by closing the first, second, third and fourth valves and by turning off the first pump; and
the second closed loop and the second open loop are taken out of service by closing the fifth, sixth, seventh and eighth valves and by turning off the second pump.

8. The cooling arrangement of claim 6 or 7, wherein:
the first closed loop and the first open loop are configured to provide sufficient cooling for maintaining a temperature of the at least one component to less than a safe temperature threshold when the second closed loop and the second open loop are taken out of service;
the second closed loop and the second open loop are configured to provide sufficient cooling for maintaining the temperature of the plurality of components to less than the safe temperature threshold when the first closed loop and the first open loop are taken out of service.

9. The cooling arrangement of any one of claims 4 to 8, wherein the second liquid-to-liquid heat exchanger is a plate heat exchanger.

10. The cooling arrangement of any one of claims 1 to 9, wherein the first liquid-to-liquid heat exchanger is a plate heat exchanger.

11. The cooling arrangement of any one of claims 1 to 10, wherein:
the rack comprises a plurality of server housings (502), each of the server housing hosting at least one component;
the at least one fan comprises at least one fan mounted in each of the server housings;
the first open loop comprises a plurality of air-to-liquid heat exchangers mounted to the rack so that heated air expelled by the at least one fan of each server housing flows through a corresponding one of the plurality of air-to-liquid heat exchangers;
each of the plurality of air-to-liquid heat exchangers is adapted to receive liquid from the first cold supply line; and
the first secondary side of the first liquid-to-liquid heat exchanger is fluidly connected to each of the plurality of air-to-liquid heat exchangers.

## Patentansprüche

1. Kühlanordnung (350) zur autonomen Kühlung eines Schranks (500), der eine Vielzahl von Komponenten (254), wobei jede der Vielzahl von Komponenten eine oder mehrere Wärme erzeugende Einheiten (252) umfasst, und mindestens einen Lüfter (12) beherbergt, wobei die Kühlanordnung umfasst:
einen ersten geschlossenen Kreislauf (510_{A}), umfassend:
eine Vielzahl von Flüssigkeitskühleinheiten (250), wobei jede der Vielzahl von Flüssigkeitskühleinheiten (250) thermisch an eine entsprechende der einen oder mehreren Wärme erzeugenden Einheiten jeder der Vielzahl von Komponenten gekoppelt ist, wobei jede der Vielzahl von Flüssigkeitskühleinheiten (250) einen ersten Flüssigkeitskanal (264) umfasst, der dazu eingerichtet ist, Wärme von der entsprechenden der einen oder mehreren Wärme erzeugenden Einheiten jeder der Vielzahl von Komponenten auf eine erste Flüssigkeit zu übertragen, die in dem ersten Flüssigkeitskanal strömt, wobei sich der erste Flüssigkeitskanal (264) jeder der Vielzahl von Flüssigkeitskühleinheiten zwischen einem ersten Flüssigkeitseinlass (256) und einem ersten Flüssigkeitsauslass (268) der entsprechenden der Vielzahl von Flüssigkeitskühleinheiten erstreckt,
eine erste Primärseite (512_{A}) eines ersten Flüssigkeit-Flüssigkeit-Wärmetauschers (514_{A}), umfassend einen zweiten Flüssigkeitseinlass (518_{A}) und einen zweiten Flüssigkeitsauslass (520_{A}), wobei die erste Seite über einen ersten Mehrfachöffnungseinlass (528_{A}) und einen Mehrfachöffnungsauslass (534_{A}) eines ersten Verteilers (526_{A}) mit dem ersten Flüssigkeitskanal der Vielzahl von Flüssigkeitskühleinheiten (250) verbunden ist, wobei der erste Mehrfachöffnungseinlass (528_{A}) eine Vielzahl von Öffnungen (530_{A}) aufweist, die mit den ersten Flüssigkeitsauslässen (268) der Vielzahl von Flüssigkeitskühleinheiten (250) strömungstechnisch verbunden ist, und der erste Mehrfachöffnungseinlass (528_{A}) eine Öffnung (532_{A}) zum Abgeben von heißer Flüssigkeit aus den Flüssigkeitskühleinheiten (250) an den zweiten Flüssigkeitseinlass (518_{A}) auf der ersten primären Seite (512_{A}) des ersten Flüssigkeit-Flüssigkeit-Wärmetauschers (514_{A}) aufweist, und der erste Mehrfachöffnungsauslass (534_{A}) eine Öffnung (536_{A}) zum Aufnehmen von Flüssigkeit, die durch den Flüssigkeit-Flüssigkeit-Wärmetauscher (514_{A}) gekühlt wurde, von dem zweiten Flüssigkeitsauslass (520_{A}) auf der ersten primären Seite (512_{A}) des ersten Flüssigkeit-Flüssigkeit-Wärmetauschers (514_{A}) aufweist und der Mehrfachöffnungsauslass (534_{A}) außerdem eine Vielzahl von Öffnungen (538_{A}) zum Abgeben dieser Flüssigkeit an die ersten Flüssigkeitseinlässe (260) der Flüssigkeitskühleinheiten (250) beinhaltet,
und eine erste Pumpe (516_{A}), die strömungstechnisch zwischen dem zweiten Flüssigkeitseinlass (518_{A}) und der einen Öffnung (532_{A}) des ersten Mehrfachöffnungseinlasses (528_{A}) verbunden ist, oder strömungstechnisch zwischen dem zweiten Flüssigkeitsauslass (520_{A}) und der einen Öffnung (536_{A}) des ersten Mehrfachöffnungsauslasses (534_{A}) verbunden ist, wobei die erste Pumpe dazu eingerichtet ist, zu bewirken, dass die erste Flüssigkeit innerhalb des ersten geschlossenen Kreislaufs strömt;
einen ersten offenen Kreislauf (540_{A}), umfassend:
einen ersten Luft-Flüssigkeit-Wärmetauscher (100_{A}, 300_{A}), der so an dem Schrank angebracht ist, dass erwärmte Luft, die durch den mindestens einen Lüfter aus dem Schrank ausgestoßen wird, durch den ersten Luft-Flüssigkeit-Wärmetauscher strömt, wobei der erste Luft-Flüssigkeit-Wärmetauscher einen dritten Flüssigkeitseinlass (106_{A}, 306_{A}) umfasst, der dazu eingerichtet ist, eine zweite Flüssigkeit von einer ersten Kaltzufuhrleitung (320_{A}) aufzunehmen, wobei der erste Luft-Flüssigkeit-Wärmetauscher ferner einen dritten Flüssigkeitsauslass (108_{A}, 308_{A}) umfasst, und
eine erste Sekundärseite (544_{A}) des ersten Flüssigkeit-Flüssigkeit-Wärmetauschers, wobei die erste Sekundärseite thermisch an die erste Primärseite gekoppelt ist, um Wärme von der ersten Primärseite auf die erste Sekundärseite zu übertragen, wenn eine Temperatur der ersten Primärseite höher ist als eine Temperatur der ersten Sekundärseite, wobei die erste Sekundärseite strömungstechnisch mit dem ersten Luft-Flüssigkeit-Wärmetauscher verbunden ist, wobei die erste Sekundärseite einen vierten Flüssigkeitseinlass (542_{A}) umfasst, der strömungstechnisch mit dem dritten Flüssigkeitsauslass des ersten Luft-Flüssigkeit-Wärmetauschers verbunden ist, und dazu eingerichtet ist, die zweite Flüssigkeit aus dem dritten Flüssigkeitsauslass des ersten Luft-Flüssigkeits-Wärmetauschers (100_{A}, 300_{A}) aufzunehmen, und die erste Sekundärseite (544_{A}) einen zum Zurückführen an die Heißrücklaufleitung (550_{A}) eingerichteten vierten Flüssigkeitsauslass (546_{A}) umfasst;
wobei der Schrank einen allgemein rechteckigen Umfang aufweist, wobei der erste Luft-Flüssigkeit-Wärmetauscher auf einer ersten Seite des Schranks positioniert ist, wobei die Kühlanordnung ferner einen Hilfsrahmen (504) umfasst, der auf einer zweiten Seite des Schranks senkrecht zu der ersten Seite montiert ist, wobei der Hilfsrahmen dazu konfiguriert ist, den ersten Flüssigkeit-Flüssigkeit-Wärmetauscher und die erste Pumpe aufzunehmen.

2. Kühlanordnung nach Anspruch 1, wobei die erste Kaltzufuhrleitung (320_{A}) dazu eingerichtet ist, mit einem Kaltauslass eines Trockenkühlers verbunden zu sein, und die erste Heißrücklaufleitung (550_{A}) dazu eingerichtet ist, mit einem Heißeinlass des Trockenkühlers verbunden zu sein.

3. Kühlanordnung nach Anspruch 1 oder 2, wobei:
die erste Pumpe mit dem zweiten Flüssigkeitseinlass der ersten Primärseite des ersten Flüssigkeit-Flüssigkeit-Wärmetauschers verbunden ist; und
der Hilfsrahmen ferner dazu konfiguriert ist, Folgendes aufzunehmen:
ein erstes Ventil (522_{A}) innerhalb einer Verbindung, die sich von dem ersten Flüssigkeitsauslass jeder der Vielzahl von Flüssigkeitskühleinheiten zu der ersten Pumpe erstreckt;
ein zweites Ventil (524_{A}) innerhalb einer Fluidverbindung, die sich von dem zweiten Flüssigkeitsauslass der ersten Primärseite des ersten Flüssigkeit-Flüssigkeit-Wärmetauschers zu dem ersten Flüssigkeitseinlass jeder der Vielzahl von Flüssigkeitskühleinheiten erstreckt;
ein drittes Ventil (570_{A}) innerhalb einer Fluidverbindung, die sich von dem dritten Flüssigkeitsauslass des ersten Luft-Flüssigkeit-Wärmetauschers zu dem vierten Flüssigkeitseinlass der ersten Sekundärseite des ersten Flüssigkeit-Flüssigkeit-Wärmetauschers erstreckt; und
ein viertes Ventil (572_{A}) innerhalb einer Fluidverbindung, die sich von dem vierten Flüssigkeitsauslass der ersten Sekundärseite des ersten Flüssigkeit-Flüssigkeit-Wärmetauschers zu der ersten Heißrücklaufleitung erstreckt.

4. Kühlanordnung nach Anspruch 1 oder 2, wobei:
jede der Vielzahl von Flüssigkeitskühleinheiten einen zweiten Flüssigkeitskanal (266) umfasst, der dazu eingerichtet ist, Wärme von der entsprechenden der Vielzahl von Wärme erzeugenden Einheiten auf eine dritte Flüssigkeit zu übertragen, die in dem zweiten Flüssigkeitskanal strömt;
wobei die Kühlanordnung ferner einen zweiten geschlossenen Kreislauf (540_{B}) umfasst, umfassend:
eine zweite Primärseite eines zweiten Flüssigkeit-Flüssigkeit-Wärmetauschers (514_{B}), wobei die zweite Primärseite über einen zweiten Mehrfachöffnungseinlass und einen zweiten Mehrfachöffnungsauslass eines zweiten Verteilers mit jedem Kanal strömungstechnisch verbunden ist, und
eine zweite Pumpe (516_{B}), die strömungstechnisch zwischen der zweiten Primärseite des zweiten Flüssigkeit-Flüssigkeit-Wärmetauschers und einem von dem zweiten Mehrfachöffnungseinlass und dem zweiten Mehrfachöffnungsauslass verbunden ist, wobei die zweite Pumpe dazu eingerichtet ist, zu bewirken, dass die dritte Flüssigkeit innerhalb des zweiten geschlossenen Kreislaufs strömt; und
wobei die Kühlanordnung ferner einen zweiten offenen Kreislauf (540_{B}) umfasst, umfassend:
einen zweiten Luft-Flüssigkeit-Wärmetauscher (100_{B}, 300_{B}), der so an dem Schrank montiert ist, dass Luft, die durch den ersten Luft-Flüssigkeit-Wärmetauscher geströmt ist, durch den zweiten Luft-Flüssigkeit-Wärmetauscher strömt, wobei der zweite Luft-Flüssigkeit-Wärmetauscher dazu eingerichtet ist, eine vierte Flüssigkeit von der ersten Kaltzufuhrleitung oder von einer zweiten Kaltzufuhrleitung aufzunehmen, und
eine zweite Sekundärseite des zweiten Flüssigkeit-Flüssigkeit-Wärmetauschers, wobei die zweite Sekundärseite thermisch an die zweite Primärseite gekoppelt ist, um Wärme von der zweiten Primärseite auf die zweite Sekundärseite zu übertragen, wenn eine Temperatur der zweiten Primärseite höher ist als eine Temperatur der zweiten Sekundärseite, wobei die zweite Sekundärseite strömungstechnisch mit dem zweiten Luft-Flüssigkeit-Wärmetauscher verbunden ist, wobei die zweite Sekundärseite dazu eingerichtet ist, die vierte Flüssigkeit zu der ersten Heißrücklaufleitung (550_{A}) oder zu einer zweiten Heißrücklaufleitung zurückzuführen.

5. Kühlanordnung nach Anspruch 4, wobei:
sich jeder zweite Flüssigkeitskanal zwischen einem fünften Flüssigkeitseinlass (258) und einem fünften Flüssigkeitsauslass (270) der entsprechenden der Vielzahl von Flüssigkeitskühleinheiten erstreckt;
die zweite Primärseite des zweiten Flüssigkeit-Flüssigkeit-Wärmetauschers einen sechsten Flüssigkeitseinlass aufweist, der über den zweiten Mehrfachöffnungseinlass strömungstechnisch mit dem fünften Flüssigkeitsauslass jeder der Vielzahl von Flüssigkeitskühleinheiten verbunden ist, wobei die zweite Primärseite ferner einen sechsten Flüssigkeitsauslass aufweist, der über den zweiten Mehrfachöffnungsauslass strömungstechnisch mit dem fünften Flüssigkeitseinlass jeder der Vielzahl von Flüssigkeitskühleinheiten verbunden ist;
der zweite Luft-Flüssigkeit-Wärmetauscher einen siebten Flüssigkeitseinlass (106_{B}, 306_{B}) umfasst, der dazu eingerichtet ist, die vierte Flüssigkeit von der ersten Kaltzufuhrleitung oder von der zweiten Kaltzufuhrleitung aufzunehmen, wobei der zweite Luft-Flüssigkeit-Wärmetauscher ferner einen siebten Flüssigkeitsauslass (108_{B}, 308_{B}) umfasst; und
die zweite Sekundärseite des zweiten Flüssigkeit-Flüssigkeit-Wärmetauschers einen achten Flüssigkeitseinlass, der strömungstechnisch mit dem siebten Flüssigkeitsauslass des zweiten ersten Flüssigkeit-Flüssigkeit-Wärmetauschers verbunden ist, und einen achten Flüssigkeitsauslass umfasst, der dazu eingerichtet ist, die zweite Flüssigkeit an die erste Heißrücklaufleitung oder die zweite Heißrücklaufleitung zurückzuführen.

6. Kühlanordnung nach Anspruch 5, wobei der Hilfsrahmen zum Aufnehmen von Folgendem konfiguriert ist:
ein erstes Modul, umfassend:
den ersten Flüssigkeit-Flüssigkeit-Wärmetauscher,
die erste Pumpe, die mit dem zweiten Flüssigkeitseinlass der ersten Primärseite des ersten Flüssigkeit-Flüssigkeit-Wärmetauschers verbunden ist;
ein erstes Ventil (522_{A}) innerhalb einer Verbindung, die sich von dem ersten Flüssigkeitsauslass jeder der Vielzahl von Flüssigkeitskühleinheiten zu der ersten Pumpe erstreckt;
ein zweites Ventil (524_{A}) innerhalb einer Fluidverbindung, die sich von dem zweiten Flüssigkeitsauslass der ersten Primärseite des ersten Flüssigkeit-Flüssigkeit-Wärmetauschers zu dem ersten Flüssigkeitseinlass jeder der Vielzahl von Flüssigkeitskühleinheiten erstreckt;
ein drittes Ventil (570_{A}) innerhalb einer Fluidverbindung, die sich von dem dritten Flüssigkeitsauslass des ersten Luft-Flüssigkeit-Wärmetauschers zu dem vierten Flüssigkeitseinlass der ersten Sekundärseite des ersten Flüssigkeit-Flüssigkeit-Wärmetauschers erstreckt; und
ein viertes Ventil (572_{A}) innerhalb einer Fluidverbindung, die sich von dem vierten Flüssigkeitsauslass der ersten Sekundärseite des ersten Flüssigkeit-Flüssigkeit-Wärmetauschers zu der ersten Heißrücklaufleitung erstreckt; und
ein zweites Modul, umfassend:
den zweiten Flüssigkeit-Flüssigkeit-Wärmetauscher,
die zweite Pumpe, die mit dem sechsten Flüssigkeitseinlass der zweiten Primärseite des zweiten Flüssigkeit-Flüssigkeit-Wärmetauschers verbunden ist;
ein fünftes Ventil (522_{B}) innerhalb einer Verbindung, die sich von dem fünften Flüssigkeitsauslass jeder der Vielzahl von Flüssigkeitskühleinheiten zu der zweiten Pumpe erstreckt;
ein sechstes Ventil (524_{B}) innerhalb einer Fluidverbindung, die sich von dem sechsten Flüssigkeitsauslass der zweiten Primärseite des zweiten Flüssigkeit-Flüssigkeit-Wärmetauschers zu dem fünften Flüssigkeitseinlass jeder der Vielzahl von Flüssigkeitskühleinheiten erstreckt;
ein siebtes Ventil (570_{B}) innerhalb einer Fluidverbindung, die sich von dem siebten Flüssigkeitsauslass des zweiten Luft-Flüssigkeit-Wärmetauschers zu dem achten Flüssigkeitseinlass der zweiten Sekundärseite des zweiten Flüssigkeit-Flüssigkeit-Wärmetauschers erstreckt; und
ein achtes Ventil (572_{B}) innerhalb einer Fluidverbindung, die sich von dem achten Flüssigkeitsauslass der zweiten Sekundärseite des zweiten Flüssigkeit-Flüssigkeit-Wärmetauschers zu der ersten Heißrücklaufleitung oder zu der zweiten Heißrücklaufleitung erstreckt.

7. Kühlanordnung nach Anspruch 6, wobei:
der erste geschlossene Kreislauf und der erste offene Kreislauf durch Schließen des ersten, zweiten, dritten und vierten Ventils und Abschalten der ersten Pumpe außer Betrieb genommen werden; und
der zweite geschlossene Kreislauf und der zweite offene Kreislauf durch Schließen des fünften, sechsten, siebten und achten Ventils und durch Abschalten der zweiten Pumpe außer Betrieb genommen werden.

8. Kühlanordnung nach Anspruch 6 oder 7, wobei:
der erste geschlossene Kreislauf und der erste offene Kreislauf dazu konfiguriert sind, eine ausreichende Kühlung bereitzustellen, um eine Temperatur der mindestens einen Komponente auf weniger als einem sicheren Temperaturschwellenwert zu halten, wenn der zweite geschlossene Kreislauf und der zweite offene Kreislauf außer Betrieb genommen werden;
der zweite geschlossene Kreislauf und der zweite offene Kreislauf dazu konfiguriert sind, eine ausreichende Kühlung bereitzustellen, um die Temperatur der Vielzahl von Komponenten auf weniger als dem sicheren Temperaturschwellenwert zu halten, wenn der erste geschlossene Kreislauf und der erste offene Kreislauf außer Betrieb genommen werden.

9. Kühlanordnung nach einem der Ansprüche 4 bis 8, wobei der zweite Flüssigkeit-Flüssigkeit-Wärmetauscher ein Plattenwärmetauscher ist.

10. Kühlanordnung nach einem der Ansprüche 1 bis 9, wobei der erste Flüssigkeit-Flüssigkeit-Wärmetauscher ein Plattenwärmetauscher ist.

11. Kühlanordnung nach einem der Ansprüche 1 bis 10, wobei:
der Schrank eine Vielzahl von Servergehäusen (502) umfasst, wobei jedes Servergehäuse mindestens eine Komponente beherbergt;
der mindestens eine Lüfter mindestens einen Lüfter umfasst, der in jedem der Servergehäuse montiert ist;
der erste offene Kreislauf eine Vielzahl von Luft-Flüssigkeit-Wärmetauschern umfasst, die so an dem Schrank montiert ist, dass erwärmte Luft, die von dem mindestens einen Lüfter jedes Servergehäuses ausgestoßen wird, durch einen entsprechenden der Vielzahl von Luft-Flüssigkeit-Wärmetauschern strömt;
jeder der Vielzahl von Luft-Flüssigkeit-Wärmetauschern dazu eingerichtet ist, Flüssigkeit von der ersten Kaltzufuhrleitung aufzunehmen; und
die erste Sekundärseite des ersten Flüssigkeit-Flüssigkeit-Wärmetauschers mit jedem der Vielzahl von Luft-Flüssigkeit-Wärmetauschern strömungstechnisch verbunden ist.

## Revendications

1. Agencement de refroidissement (350) pour le refroidissement autonome d'un bâti (500) hébergeant une pluralité de composants (254), chacun de la pluralité de composants comprenant une ou plusieurs unités de génération de la chaleur (252), et au moins une soufflante (12), dans lequel l'agencement de refroidissement comprend :
une première boucle fermée (510_{A}) comprenant :
une pluralité d'unités de refroidissement de liquide (250), chacune de la pluralité d'unités de refroidissement de liquide (250) étant couplée thermiquement à une unité correspondante parmi l'une ou les plusieurs unités de génération de la chaleur de chacun de la pluralité de composants, chacune de la pluralité d'unités de refroidissement de liquide (250) comprenant un premier canal de liquide (264) conçu pour transférer de la chaleur de l'une ou des plusieurs unités de génération de la chaleur correspondantes de chacun de la pluralité de composants à un premier liquide s'écoulant dans le premier canal de liquide, le premier canal de liquide (264) de chacune de la pluralité d'unités de refroidissement de liquide s'étendant entre une première entrée de liquide (256) et une première sortie de liquide (268) de l'unité de refroidissement de liquide correspondante parmi la pluralité d'unités de refroidissement de liquide,
un premier côté primaire (512_{A}) d'un premier échangeur de chaleur liquide-liquide (514_{A}) comprenant une deuxième entrée de liquide (518_{A}) et une deuxième sortie de liquide (520_{A}), le premier côté primaire étant en communication fluidique, par l'intermédiaire d'une première entrée multi-orifices (528_{A}) et d'une première sortie multi-orifices (534_{A}) d'un premier collecteur (526_{A}), avec le premier canal de liquide de chacune de la pluralité d'unités de refroidissement de liquide (250), la première entrée multi-orifices (528_{A}) ayant une pluralité d'orifices (530_{A}) reliés fluidiquement aux premières sorties de liquide (268) de la pluralité d'unités de refroidissement de liquide (250) et la première entrée multi-orifices (528_{A}) ayant un orifice (532_{A}) pour délivrer du liquide chaud des unités de refroidissement de liquide (250) à la deuxième entrée de liquide (518_{A}) sur le premier côté primaire (512_{A}) du premier échangeur de chaleur liquide-liquide (514_{A}), et de la première sortie multi-orifices (534_{A}) ayant un orifice (536_{A}) pour recevoir le liquide, ayant été refroidi par l'échangeur de chaleur liquide-liquide (514_{A}), de la deuxième sortie de liquide (520_{A}) sur le premier côté primaire (512_{A}) du premier échangeur de chaleur liquide-liquide (514_{A}) et la sortie multi-orifices (534_{A}) comporte également une pluralité d'orifices (538_{A}) pour délivrer ce liquide aux premières entrées de liquide (260) des unités de refroidissement de liquide (250),
et une première pompe (516_{A}) en communication fluidique entre la deuxième entrée de liquide (518_{A}) et le premier orifice (532_{A}) de la première entrée multi-orifices (528_{A}), ou en communication fluidique entre la deuxième sortie de liquide (520_{A}) et le premier orifice (536_{A}) de la première sortie multi-orifices (534_{A}), la première pompe étant conçue pour faire circuler le premier liquide dans la première boucle fermée ;
une première boucle ouverte (540_{A}) comprenant :
un premier échangeur de chaleur air-liquide (100_{A}, 300_{A}) monté sur le bâti de sorte que l'air chauffé expulsé du bâti par l'au moins une soufflante s'écoule à travers le premier échangeur de chaleur air-liquide, le premier échangeur de chaleur air-liquide comprenant une troisième entrée de liquide (106_{A}, 306_{A}) conçue pour recevoir un deuxième liquide provenant d'une première conduite d'alimentation froide (320_{A}), le premier échangeur de chaleur air-liquide comprenant également une troisième sortie de liquide (108_{A}, 308_{A}), et
un premier côté secondaire (544_{A}) du premier échangeur de chaleur liquide-liquide, le premier côté secondaire étant couplé thermiquement au premier côté primaire pour le transfert de chaleur du premier côté primaire au premier côté secondaire lorsqu'une température du premier côté primaire est supérieure à une température du premier côté secondaire, le premier côté secondaire étant en communication fluidique avec le premier échangeur de chaleur air-liquide, le premier côté secondaire comprenant une quatrième entrée de liquide (542_{A}) en communication fluidique avec la troisième sortie de liquide du premier échangeur de chaleur air-liquide, et étant conçu pour recevoir le deuxième liquide de la troisième sortie de liquide du premier échangeur de chaleur air-liquide (100_{A}, 300_{A}) et du premier côté secondaire (544_{A}) comprenant une quatrième sortie de liquide (546_{A}) conçue pour renvoyer le deuxième liquide vers une première ligne de retour chaude (550_{A}) ;
dans lequel le bâti a un périmètre généralement rectangulaire, le premier échangeur de chaleur air-liquide étant positionné sur un premier côté du bâti, l'agencement de refroidissement comprenant également un sous-cadre (504) monté sur un second côté du bâti perpendiculaire au premier côté, le sous-cadre étant configuré pour recevoir le premier échangeur de chaleur liquide-liquide et la première pompe.

2. Agencement de refroidissement selon la revendication 1, dans lequel la première ligne d'alimentation froide (320_{A}) est conçue pour être reliée à une sortie froide d'un refroidisseur sec et la première ligne de retour chaude (550_{A}) est conçue pour être reliée à une entrée chaude du refroidisseur sec.

3. Agencement de refroidissement selon la revendication 1 ou 2, dans lequel :
la première pompe est reliée à la deuxième entrée de liquide du premier côté primaire du premier échangeur de chaleur liquide-liquide ; et
la sous-trame est également configurée pour recevoir :
une première vanne (522_{A}) à l'intérieur d'un raccord s'étendant de la première sortie de liquide de chacune de la pluralité d'unités de refroidissement de liquide à la première pompe ;
une deuxième vanne (524_{A}) à l'intérieur d'une liaison fluidique s'étendant de la deuxième sortie de liquide du premier côté primaire du premier échangeur de chaleur liquide-liquide à la première entrée de liquide de chacune de la pluralité d'unités de refroidissement de liquide ;
une troisième vanne (570_{A}) à l'intérieur d'une liaison fluidique s'étendant de la troisième sortie de liquide du premier échangeur de chaleur air-liquide à la quatrième entrée de liquide du premier côté secondaire du premier échangeur de chaleur liquide-liquide ; et
une quatrième vanne (572_{A}) à l'intérieur d'une liaison fluidique s'étendant de la quatrième sortie de liquide du premier côté secondaire du premier échangeur de chaleur liquide-liquide jusqu'à la première ligne de retour chaude.

4. Agencement de refroidissement selon la revendication 1 ou 2, dans lequel :
chacune de la pluralité d'unités de refroidissement de liquide comprend un second canal de liquide (266) conçu pour transférer de la chaleur de l'unité correspondante de la pluralité d'unités de génération de chaleur à un troisième liquide s'écoulant dans le second canal de liquide ;
l'agencement de refroidissement comprend également une seconde boucle fermée (540_{B}) comprenant :
un second côté primaire d'un second échangeur de chaleur liquide-liquide (514_{B}), le second primaire étant en communication fluidique, par l'intermédiaire d'une seconde entrée multi-orifices et d'une seconde sortie multi-orifices d'un second collecteur, avec chaque canal, et
une seconde pompe (516_{B}) en communication fluidique entre le second côté primaire du second échangeur de chaleur liquide-liquide et l'une de la seconde entrée multi-orifices et de la seconde sortie multi-orifices, la seconde pompe étant conçue pour faire circuler le troisième liquide dans la seconde boucle fermée ; et
l'agencement de refroidissement comprend également une seconde boucle ouverte (540_{B}) comprenant :
un second échangeur de chaleur air-liquide (100_{B}, 300_{B}) monté sur le bâti de sorte que de l'air ayant circulé dans le premier échangeur de chaleur air-liquide circule dans le second échangeur de chaleur air-liquide, le second échangeur de chaleur air-liquide étant conçu pour recevoir un quatrième liquide de la première ligne d'alimentation froide ou d'une seconde ligne d'alimentation froide, et
un second côté secondaire du second échangeur de chaleur liquide-liquide, le second côté secondaire étant couplé thermiquement au second côté primaire pour un transfert de chaleur du second côté primaire au second côté secondaire lorsqu'une température du second côté primaire est supérieure à une température du second côté secondaire, le second côté secondaire étant en communication fluidique avec le second échangeur de chaleur air-liquide, le second côté secondaire étant conçu pour renvoyer le quatrième liquide vers la première ligne de retour chaude (550_{A}) ou vers une seconde ligne de retour chaude.

5. Agencement de refroidissement selon la revendication 4, dans lequel :
chaque second canal de liquide s'étend entre une cinquième entrée de liquide (258) et une cinquième sortie de liquide (270) de l'unité de refroidissement de liquide correspondante de la pluralité d'unités de refroidissement de liquide ;
le second côté primaire du second échangeur de chaleur liquide-liquide comprend une sixième entrée de liquide reliée fluidiquement, par la seconde entrée multi-orifices, à la cinquième sortie de liquide de chacune de la pluralité d'unités de refroidissement de liquide, le second côté primaire comprenant également une sixième sortie de liquide reliée fluidiquement, par l'intermédiaire de la seconde sortie multi-orifices, à la cinquième entrée de liquide de chacune de la pluralité d'unités de refroidissement de liquide ;
le second échangeur de chaleur air-liquide comprend une septième entrée de liquide (106_{B}, 306_{B}) conçu pour recevoir le quatrième liquide de la première ligne d'alimentation froide ou de la seconde ligne d'alimentation froide, le second échangeur de chaleur air-liquide comprenant également une septième sortie de liquide (108_{B}, 308_{B}) ; et
le second côté secondaire du second échangeur de chaleur liquide-liquide comprend une huitième entrée de liquide reliée fluidiquement à la septième sortie de liquide du second premier échangeur de chaleur air-liquide et une huitième sortie de liquide conçue pour renvoyer le deuxième liquide vers la première ligne de retour chaude ou vers la seconde ligne de retour chaude.

6. Agencement de refroidissement selon la revendication 5, dans lequel le sous-cadre est configuré pour recevoir :
un premier module comprenant :
le premier échangeur de chaleur liquide-liquide ;
la première pompe étant reliée à la deuxième entrée de liquide du premier côté primaire du premier échangeur de chaleur liquide-liquide ;
une première vanne (522_{A}) à l'intérieur d'un raccord s'étendant de la première sortie de liquide de chacune de la pluralité d'unités de refroidissement de liquide à la première pompe ;
une deuxième vanne (524_{A}) à l'intérieur d'une liaison fluidique s'étendant de la deuxième sortie de liquide du premier côté primaire du premier échangeur de chaleur liquide-liquide à la première entrée de liquide de chacune de la pluralité d'unités de refroidissement de liquide ;
une troisième vanne (570_{A}) à l'intérieur d'une liaison fluidique s'étendant de la troisième sortie de liquide du premier échangeur de chaleur air-liquide à la quatrième entrée de liquide du premier côté secondaire du premier échangeur de chaleur liquide-liquide ; et
une quatrième vanne (572_{A}) à l'intérieur d'une liaison fluidique s'étendant de la quatrième sortie de liquide du premier côté secondaire du premier échangeur de chaleur liquide-liquide jusqu'à la première ligne de retour chaude ; et
un second module comprenant :
le second échangeur de chaleur liquide-liquide ;
la seconde pompe étant reliée à la sixième entrée de liquide du second côté primaire du second échangeur de chaleur liquide-liquide ;
une cinquième vanne (522_{B}) à l'intérieur d'un raccord s'étendant de la cinquième sortie de liquide de chacune de la pluralité d'unités de refroidissement de liquide à la seconde pompe ;
une sixième vanne (524_{B}) à l'intérieur d'une liaison fluidique s'étendant de la sixième sortie de liquide du second côté primaire du second échangeur de chaleur liquide-liquide à la cinquième entrée de liquide de chacune de la pluralité d'unités de refroidissement de liquide ;
une septième vanne (570_{B}) à l'intérieur d'une liaison fluidique s'étendant de la septième sortie de liquide du second échangeur de chaleur air-liquide à la huitième entrée de liquide du second côté secondaire du second échangeur de chaleur liquide-liquide ; et
une huitième vanne (572_{B}) à l'intérieur d'une liaison fluidique s'étendant de la huitième sortie de liquide du second côté secondaire du second échangeur de chaleur liquide-liquide à la première ligne de retour chaude ou à la seconde ligne de retour chaude.

7. Agencement de refroidissement selon la revendication 6, dans lequel :
la première boucle fermée et la première boucle ouverte sont mises hors service en fermant les première, deuxième, troisième et quatrième vannes et en arrêtant la première pompe ; et
la seconde boucle fermée et la seconde boucle ouverte sont mises hors service en fermant les cinquième, sixième, septième et huitième vannes et en arrêtant la seconde pompe.

8. Agencement de refroidissement selon la revendication 6 ou 7, dans lequel :
la première boucle fermée et la première boucle ouverte sont configurées pour assurer un refroidissement suffisant pour maintenir une température de l'au moins un composant inférieure à un seuil de température de sécurité lorsque la seconde boucle fermée et la seconde boucle ouverte sont mises hors service ;
la seconde boucle fermée et la seconde boucle ouverte sont configurées pour assurer un refroidissement suffisant pour maintenir la température de la pluralité de composants inférieure à un seuil de température de sécurité lorsque la première boucle fermée et la première boucle ouverte sont mises hors service.

9. Agencement de refroidissement selon l'une quelconque des revendications 4 à 8, dans lequel le second échangeur de chaleur liquide-liquide est un échangeur de chaleur à plaques.

10. Agencement de refroidissement selon l'une quelconque des revendications 1 à 9, dans lequel le premier échangeur de chaleur liquide-liquide est un échangeur de chaleur à plaques.

11. Agencement de refroidissement selon l'une quelconque des revendications 1 à 10, dans lequel :
le bâti comprend une pluralité de boîtiers de serveurs (502), chacun des boîtiers de serveurs hébergeant au moins un composant ;
l'au moins une soufflante comprend au moins une soufflante montée dans chacun des boîtiers de serveurs ;
la première boucle ouverte comprend une pluralité d'échangeurs de chaleur air-liquide montés sur le bâti de sorte que l'air chauffé expulsé par l'au moins une soufflante de chaque boîtier de serveur circule à travers un échangeur de chaleur air-liquide correspondant de la pluralité d'échangeurs de chaleur air-liquide ;
chacun de la pluralité d'échangeurs de chaleur air-liquide est conçu pour recevoir du liquide provenant de la première ligne d'alimentation froide ; et
le premier côté secondaire du premier échangeur de chaleur liquide-liquide est en communication fluidique avec chacun de la pluralité d'échangeurs de chaleur air-liquide.
